(19) Europäisches Patentamt
European Patent Office
Office européen des brevets

(11) EP 2 500 397 A1

(12) # EUROPEAN PATENT APPLICATION
published in accordance with Art. 153(4) EPC

(43) Date of publication:
**19.09.2012 Bulletin 2012/38**

(21) Application number: **10830937.8**

(22) Date of filing: **15.12.2010**

(51) Int Cl.:
***C09K 11/06*** *(2006.01)* ***H01L 51/50*** *(2006.01)*

(86) International application number:
**PCT/JP2010/007270**

(87) International publication number:
**WO 2011/074253 (23.06.2011 Gazette 2011/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.12.2009 JP 2009284970**

(71) Applicant: **Idemitsu Kosan Co., Ltd.**
**Chiyoda-ku**
**Tokyo 100-8321 (JP)**

(72) Inventors:
- **KAWAMURA, Masahiro**
**Sodegaura-shi**
**Chiba 299-0293 (JP)**
- **MIZUKI, Yumiko**
**Sodegaura-shi**
**Chiba 299-0293 (JP)**

(74) Representative: **Gille Hrabal**
**Patentanwälte**
**Brucknerstrasse 20**
**40593 Düsseldorf (DE)**

(54) **ORGANIC LIGHT-EMITTING MEDIUM**

(57) An organic luminescent medium including an aromatic amine derivative represented by the following formula (1) and an anthracene derivative represented by the following formula (I):

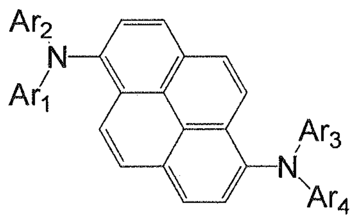

(1)

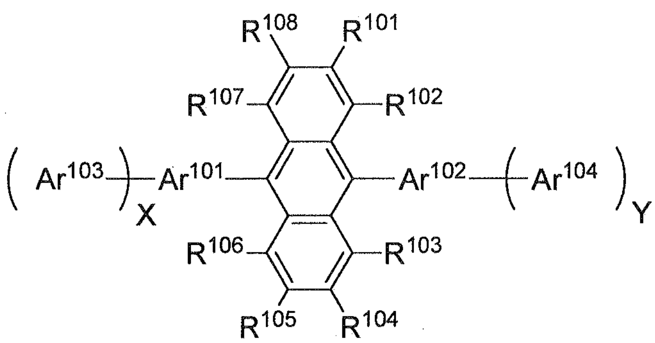

(I)

EP 2 500 397 A1

## Description

TECHNICAL FIELD

The invention relates to an organic luminescent medium using an aromatic amine derivative and an anthracene derivative, and an organic electroluminescence device.

BACKGROUND ART

An organic electroluminescence (EL) device using an organic substance is a promising solid-state emitting type inexpensive and large full-color display device, and has been extensively developed. In general, an organic EL device includes an emitting layer and a pair of opposing electrodes holding the emitting layer therebetween. When an electric field is applied between the electrodes, electrons are injected from the cathode and holes are injected from the anode. Emission is a phenomenon in which the electrons recombine with the holes in the emitting layer to produce an excited state, and energy is emitted as light when the excited state returns to the ground state.

The performance of an organic EL device has been gradually improved with improvements in emitting materials for an organic EL device. In particular, improvement in color purity of a blue-emitting organic EL device is an important factor leading to high color reproducibility of a display.

As examples of a material for an emitting layer, patent documents 1 to 8 disclose diaminopyrene derivatives. In particular, patent documents 1 and 2 disclose that a blue light emission having a short wave length can be obtained. However, there is a problem that the lifetime of the devices obtained by using these derivatives is short.

[Patent Document 1] Korean patent publication No. 10-2007-0115588
[Patent Document 2] Korean patent publication No. 10-2008-0079956
[Patent Document 3] WO2005/108348
[Patent Document 4] WO2004/018588
[Patent Document 5] WO2004/018587
[Patent Document 6] WO2009/102054
[Patent Document 7] WO2009/102026
[Patent Document 8] WO2009/107596

DISCLOSURE OF THE INVENTION

An object of the invention is to provide an organic luminescent medium which enables an organic EL device which can emit blue light which is high in color purity and has a long lifetime.

According to the invention, the following organic luminescent medium and the like are provided.

1. An organic luminescent medium comprising an aromatic amine derivative represented by the following formula (1) and an anthracene derivative represented by the following formula (I):

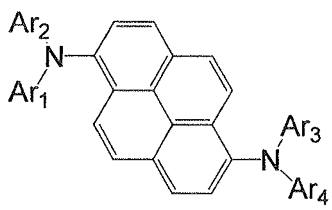

(1)

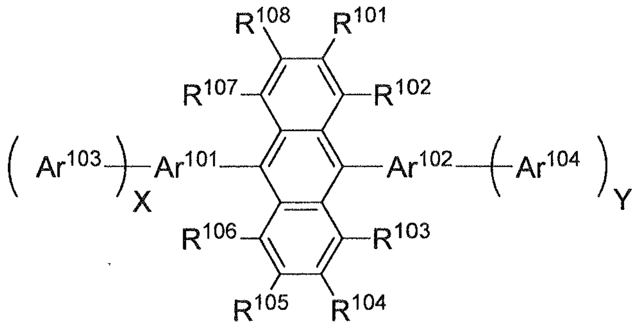

(I)

wherein in formula (1), $Ar_1$ to $Ar_4$ are independently a substituted or unsubstituted aryl group having 6 to 30 carbon atoms that form a ring (hereinafter referred to as "ring carbon atoms"), and at least one of $Ar_1$ to $Ar_4$ is an aryl group having an electron-attracting group,
in formula (I), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms, or a substituted or unsubstituted heterocyclic group having 5 to 30 atoms that form a ring (hereinafter referred to as "ring atoms"),
$Ar^{101}$ to $Ar^{104}$ are a substituted or unsubstituted aryl group having 6 to 30 ring carbon atoms or a substituted or unsubstituted heterocyclic group having 5 to 30 ring atoms,
X is an integer of 0 to 3, and
Y is an integer of 1 to 3.

2. An organic luminescent medium comprising an aromatic amine derivative represented by the following formula (1) and an anthracene derivative represented by the following formula (II):

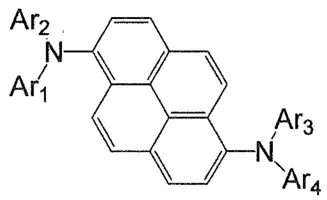

(1)

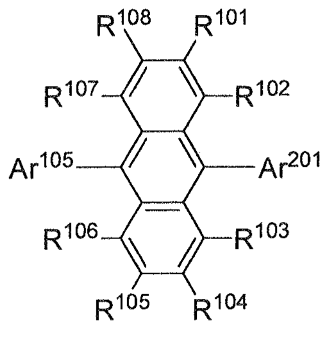

(II)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,
in formula (II), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms, or a substituted or unsubstituted heterocyclic group having 5 to 30 ring atoms,
$Ar^{105}$ is a substituted or unsubstituted aryl group having 6 to 30 ring carbon atoms or a substituted or unsubstituted

heterocyclic group having 5 to 30 ring atoms, and
$Ar^{201}$ is a substituted or unsubstituted fused aromatic ring group having 16 to 30 ring carbon atoms, or a substituted or unsubstituted fused heterocyclic group having 10 to 30 ring atoms.

3. An organic luminescent medium comprising an aromatic amine derivative represented by the following formula (1) and an anthracene derivative represented by the following formula (III):

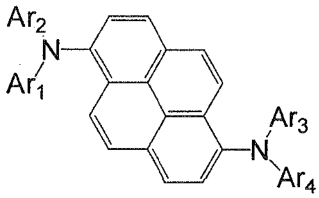
(1)

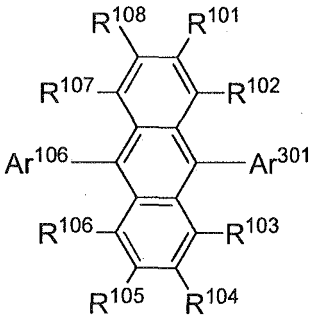
(III)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,
in formula (III), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms, or a substituted or unsubstituted heterocyclic group having 5 to 30 ring atoms,
$Ar^{106}$ is a substituted or unsubstituted aryl group having 6 to 30 ring carbon atoms or a substituted or unsubstituted heterocyclic group having 5 to 30 ring atoms, and
$Ar^{301}$ is a substituted or unsubstituted 2-naphthyl group or a substituted or unsubstituted fluorenyl group, provided that $Ar^{106}$ and $Ar^{301}$ are different.

4. An organic luminescent medium comprising an aromatic amine derivative represented by the following formula (1) and an anthracene derivative represented by the following formula (10):

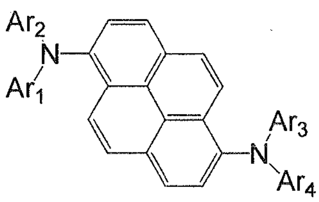
(1)

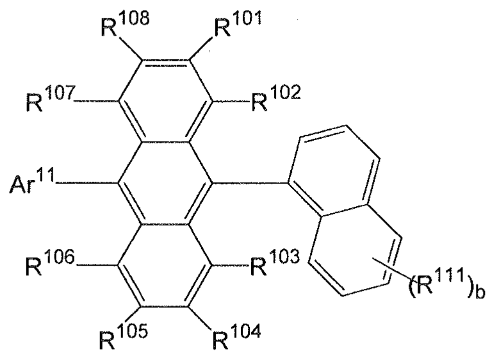

(10)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,

in formula (10), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms, or a substituted or unsubstituted heterocyclic group having 5 to 30 ring atoms,

$Ar^{11}$ is a substituted or unsubstituted phenyl group, substituted or unsubstituted 2-naphthyl group or a substituted or unsubstituted heterocyclic group having 5 to 30 ring atoms,

$R^{111}$ is a substituted or unsubstituted aryl group having 6 to 30 ring carbon atoms, a substituted or unsubstituted heterocyclic group having 5 to 30 ring atoms, a substituted or unsubstituted alkyl group having 1 to 10 carbon atoms, a substituted or unsubstituted cycloalkyl group having 3 to 10 ring carbon atoms, a substituted or unsubstituted alkoxy group having 1 to 20 carbon atoms, a substituted or unsubstituted silyl group, a cyano group or a fluorine atom, and

b is an integer of 0 to 7, and plural $R^{111}$s may be the same or different when b is an integer of 2 or more.

5. The organic luminescent medium according to 4 wherein the anthracene derivative is represented by the following formula (11):

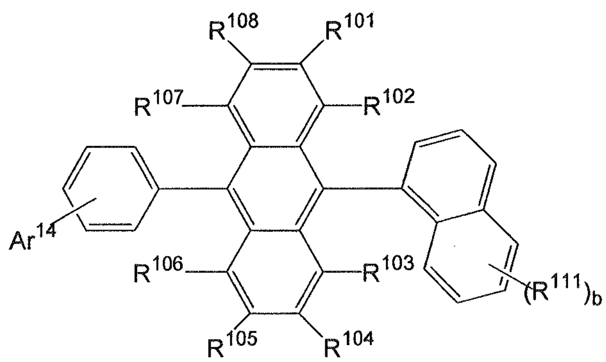

(11)

wherein $R^{101}$ to $R^{108}$, $R^{111}$ and b are the same as those in formula (10), and

$Ar^{14}$ is a substituted or unsubstituted aryl group having 6 to 30 ring carbon atoms, a substituted or unsubstituted alkyl group having 1 to 10 carbon atoms, a substituted or unsubstituted cycloalkyl group having 3 to 10 ring carbon atoms or a substituted or unsubstituted heterocyclic group having 5 to 30 ring atoms.

6. An organic luminescent medium comprising an aromatic amine derivative represented by the following formula (1) and an anthracene derivative represented by the following formula (12):

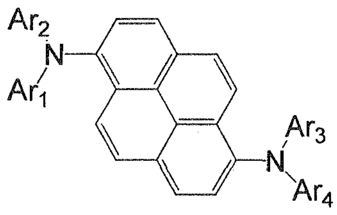

(1)

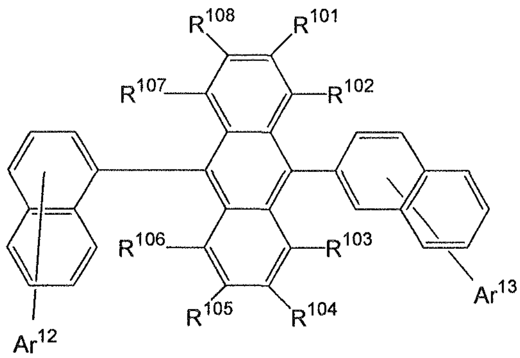

(12)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,
in formula (12), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms, and
$Ar^{12}$ and $Ar^{13}$ are independently a hydrogen atom, an aryl group having 6 to 30 ring carbon atoms, or a substituted or unsubstituted heterocyclic group having 5 to 30 ring atoms, and $Ar^{12}$ may form a ring with the naphthalene ring to which $Ar^{12}$ bonds.

7. An organic luminescent medium comprising an aromatic amine derivative represented by the following formula (1) and an anthracene derivative represented by the following formula (13):

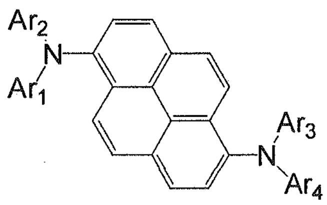

(1)

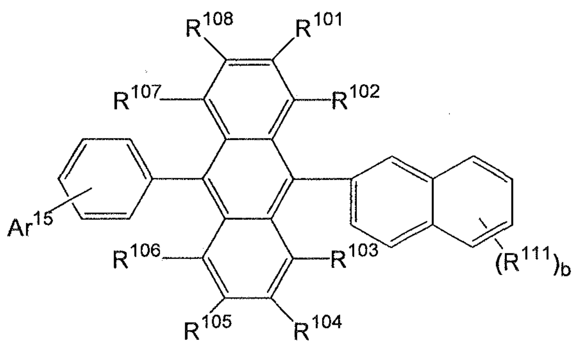

(13)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,
in formula (13), $R^{101}$ to $R^{108}$ and $R^{111}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms,
$Ar^{15}$ is a substituted or unsubstituted aryl group having 6 to 30 ring carbon atoms, a substituted or unsubstituted alkyl group having 1 to 10 carbon atoms, a substituted or unsubstituted cycloalkyl group having 3 to 10 ring carbon atoms or a substituted or unsubstituted heterocyclic group having 5 to 30 ring atoms, and
b is an integer of 0 to 7, and plural $R^{111}$s may be the same or different when b is an integer of 2 or more.

8. An organic luminescent medium comprising an aromatic amine derivative represented by the following formula (1) and an anthracene derivative represented by the following formula (14):

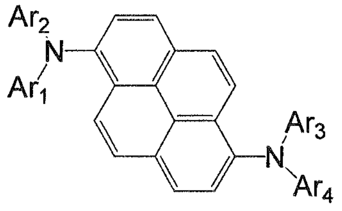

(1)

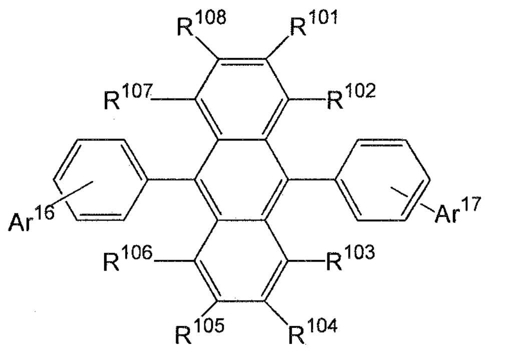

(14)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,
in formula (14), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms,
$Ar^{16}$ is a substituted or unsubstituted aryl group having 6 to 30 ring carbon atoms, a substituted or unsubstituted alkyl group having 1 to 10 carbon atoms, a substituted or unsubstituted cycloalkyl group having 3 to 10 ring carbon atoms or a substituted or unsubstituted heterocyclic group having 5 to 50 ring atoms, and $Ar^{16}$ may form a ring with the benzene ring to which $Ar^{16}$ bonds, and
$Ar^{17}$ is a substituted or unsubstituted aryl group having 6 to 30 ring carbon atoms, a substituted or unsubstituted alkyl group having 1 to 10 carbon atoms, a substituted or unsubstituted cycloalkyl group having 3 to 10 ring carbon atoms or a substituted or unsubstituted heterocyclic group having 5 to 30 ring atoms.

9. An organic luminescent medium comprising an aromatic amine derivative represented by the following formula (1) and an anthracene derivative represented by the following formula (15):

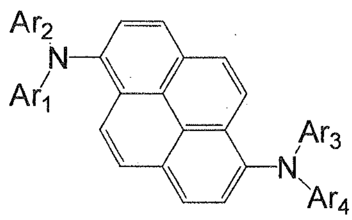

(1)

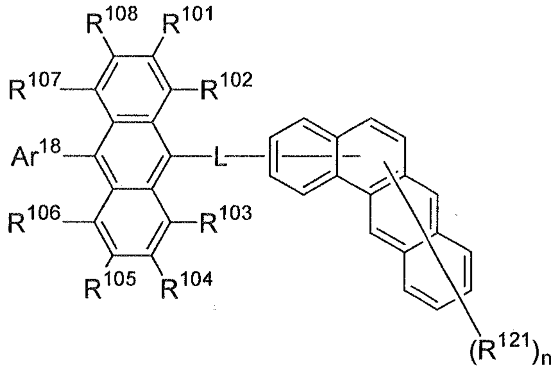

(15)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,

in formula (15), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms, or a substituted or unsubstituted heterocyclic group having 5 to 30 ring atoms,

$Ar^{18}$ is a substituted or unsubstituted aryl group having 6 to 30 ring carbon atoms or a substituted or unsubstituted heterocyclic group having 5 to 30 ring atoms,

L is a single bond, a substituted or unsubstituted arylene group having 6 to 30 ring carbon atoms or a substituted or unsubstituted divalent heterocyclic group having 5 to 30 ring atoms,

$R^{121}$ is a substituted or unsubstituted aryl group having 6 to 30 ring carbon atoms, a substituted or unsubstituted heterocyclic group having 5 to 30 ring atoms, a substituted or unsubstituted alkyl group having 1 to 10 carbon atoms, a substituted or unsubstituted cycloalkyl group having 3 to 10 ring carbon atoms, a substituted or unsubstituted alkoxy group having 1 to 20 carbon atoms, a substituted or unsubstituted silyl group, a cyano group or a fluorine atom, and

n is an integer of 0 to 11, and plural $R^{121}$s may be the same or different when n is an integer of 2 or more.

10. An organic luminescent medium comprising an aromatic amine derivative represented by the following formula (1) and an anthracene derivative represented by the following formula (16):

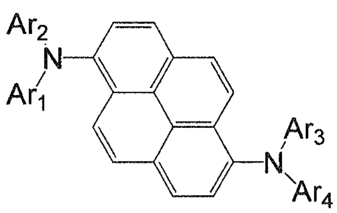

(1)

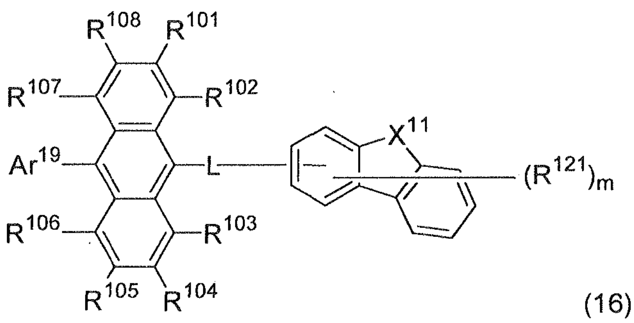

(16)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,
in formula (16), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms,
L is a single bond, a substituted or unsubstituted arylene group having 6 to 50 ring carbon atoms or a substituted or unsubstituted divalent heterocyclic group having 5 to 50 ring atoms,
$Ar^{19}$ is a substituted or unsubstituted aryl group having 6 to 30 ring carbon atoms or a substituted or unsubstituted heterocyclic group having 5 to 30 ring atoms,
$X^{11}$ is an oxygen atom, a sulfur atom, -NR- or $-CR^aR^b$, wherein R, $R^a$ and $R^b$ are the same group as those in $R^{101}$ to $R^{108}$,
$R^{121}$ is a substituted or unsubstituted aryl group having 6 to 30 ring carbon atoms or a substituted or unsubstituted heterocyclic group having 5 to 30 ring atoms, a substituted or unsubstituted alkyl group having 1 to 10 carbon atoms, a substituted or unsubstituted cycloalkyl group having 3 to 10 ring carbon atoms, a substituted or unsubstituted alkoxy group having 1 to 20 carbon atoms, a substituted or unsubstituted silyl group, a cyano group or a fluorine atom, and
m is an integer of 0 to 7, and plural $R^{121}$s may be the same or different when m is an integer of 2 or more.

11. An organic luminescent medium comprising an aromatic amine derivative represented by the following formula (1) and an anthracene derivative represented by the following formula (17):

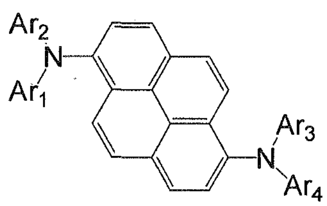

(1)

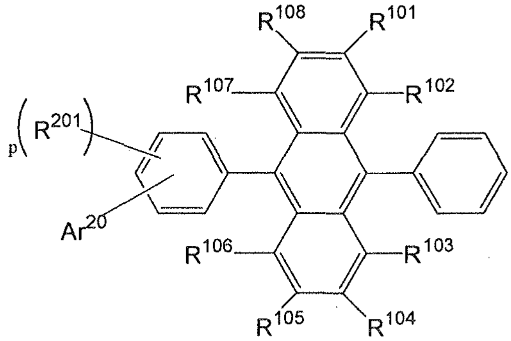

(17)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,

in formula (17), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms,

$Ar^{20}$ is a substituted or unsubstituted aryl group having 6 to 30 ring carbon atoms or a substituted or unsubstituted heterocyclic group having 5 to 30 ring atoms,

$R^{201}$ is a substituted or unsubstituted aryl group having 6 to 30 ring carbon atoms, a substituted or unsubstituted heterocyclic group having 5 to 30 ring atoms, a substituted or unsubstituted alkyl group having 1 to 10 carbon atoms, a substituted or unsubstituted cycloalkyl group having 3 to 10 ring carbon atoms, a substituted or unsubstituted alkoxy group having 1 to 20 carbon atoms, a substituted or unsubstituted silyl group, a cyano group or a fluorine atom, and

p is an integer of 0 to 4, and plural $R^{201}$s may be the same or different when p is an integer of 2 or more.

12. An organic luminescent medium comprising an aromatic amine derivative represented by the following formula (1) and an anthracene derivative represented by the following formula (18):

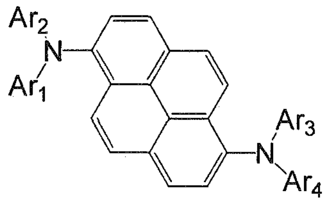

(1)

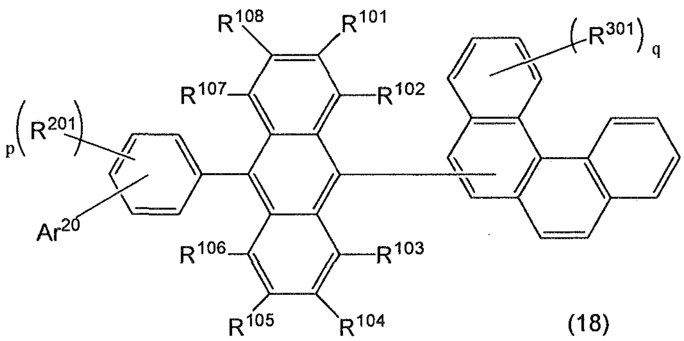

(18)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,

in formula (18), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms,

$Ar^{20}$ is a substituted or unsubstituted aryl group having 6 to 30 ring carbon atoms or a substituted or unsubstituted heterocyclic group having 5 to 30 ring atoms,

$R^{201}$ and $R^{301}$ are a substituted or unsubstituted aryl group having 6 to 30 ring carbon atoms or a substituted or unsubstituted heterocyclic group having 5 to 30 ring atoms, a substituted or unsubstituted alkyl group having 1 to 10 carbon atoms, a substituted or unsubstituted cycloalkyl group having 3 to 10 ring carbon atoms, a substituted or unsubstituted alkoxy group having 1 to 20 carbon atoms, a substituted or unsubstituted silyl group, a cyano group or a fluorine atom,

p is an integer of 0 to 4, and plural $R^{201}$s may be the same or different when p is an integer of 2 or more,

q is an integer of 0 to 11, plural $R^{301}$s may be the same or different when q is an integer of 2 or more, and adjacent substituents may form a saturated or unsaturated ring.

13. The organic luminescent medium according to any one of 1 to 12 wherein the aromatic amine derivative is

represented by the following formula (2):

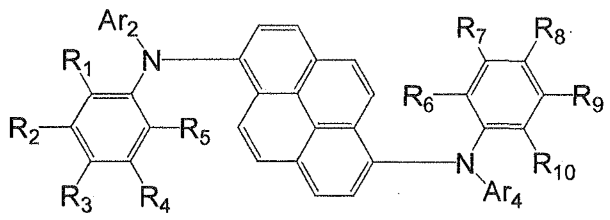

(2)

wherein $Ar_2$ and $Ar_4$ are the same as those in formula (1),
$R_1$ to $R_{10}$ are independently a hydrogen atom, a halogen atom, a substituted or unsubstituted alkyl group having 1 to 20 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aralkyl group having 6 to 20 ring carbon atoms, a substituted or unsubstituted aryl group having 6 to 10 ring carbon atoms or an electron-attracting group, and
at least one of $R_1$ to $R_5$ is an electron-attracting group, and at least one of $R_6$ to $R_{10}$ is an electron-attracting group.
14. The organic luminescent medium according to 13 wherein at least one of $R_1$ to $R_5$ is an electron-attracting group and the other groups are a hydrogen atom, and at least one of $R_6$ to $R_{10}$ is an electron-attracting group and the other groups are a hydrogen atom.
15. The organic luminescent medium according to any one of 1 to 14 wherein the electron-attracting group is a cyano group.
16. An organic thin film comprising the organic luminescent medium according to any one of 1 to 15.
17. An organic electroluminescence device comprising one or more organic thin film layers comprising an emitting layer between an anode and an cathode,

wherein at least one layer of the organic thin film layers is the organic thin film according to 16.

According to the invention, an organic luminescent medium which can emit blue light which is high in color purity and has a long lifetime can be provided.

BEST MODE FOR CARRYING OUT THE INVENTION

The organic luminescent medium of the invention comprises an aromatic amine derivative represented by the following formula (1) and an anthracene derivative represented by the following formula (I):

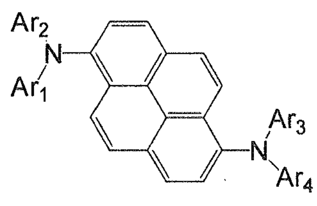

(1)

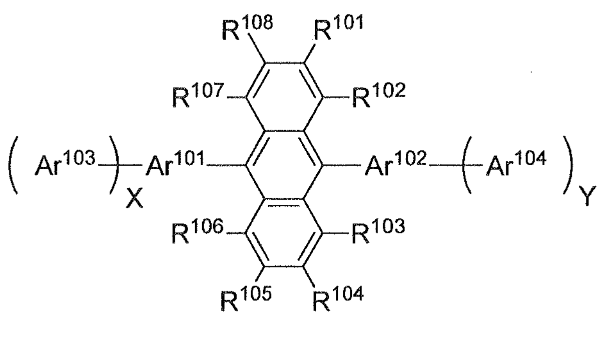

(I)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,

in formula (I), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms, or a substituted or unsubstituted heterocyclic group having 5 to 30 ring atoms,
$Ar^{101}$ to $Ar^{104}$ are a substituted or unsubstituted aryl group having 6 to 30 ring carbon atoms or a substituted or unsubstituted heterocyclic group having 5 to 30 ring atoms,
X is an integer of 0 to 3, and
Y is an integer of 1 to 3.

The organic luminescent medium of the invention comprises an aromatic amine derivative represented by the following formula (1) and an anthracene derivative represented by the following formula (II):

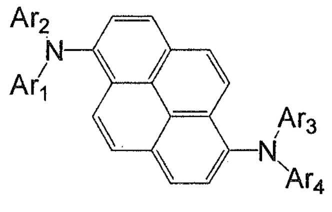

(1)

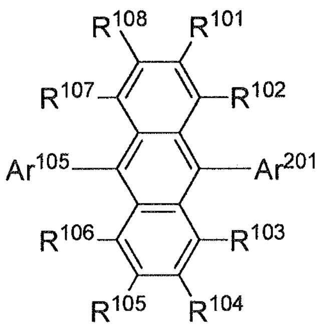

(II)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,
in formula (II), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms, or a substituted or unsubstituted heterocyclic group having 5 to 30 ring atoms,
$Ar^{105}$ is a substituted or unsubstituted aryl group having 6 to 30 ring carbon atoms or a substituted or unsubstituted heterocyclic group having 5 to 30 ring atoms, and
$Ar^{201}$ is a substituted or unsubstituted fused aromatic ring group having 16 to 30 ring carbon atoms, or a substituted or unsubstituted fused heterocyclic group having 10 to 30 ring atoms.

The organic luminescent medium of the invention comprises an aromatic amine derivative represented by the following formula (1) and an anthracene derivative represented by the following formula (III):

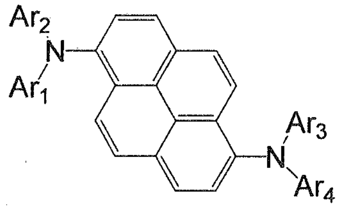

(1)

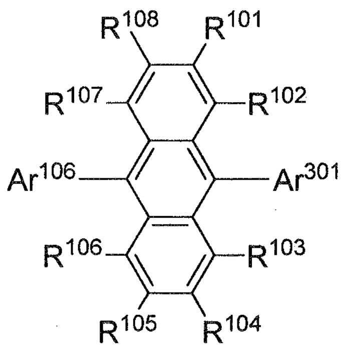

(III)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,

in formula (III), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms, or a substituted or unsubstituted heterocyclic group having 5 to 30 ring atoms,

$Ar^{106}$ is a substituted or unsubstituted aryl group having 6 to 30 ring carbon atoms or a substituted or unsubstituted heterocyclic group having 5 to 30 ring atoms, and

$Ar^{301}$ is a substituted or unsubstituted 2-naphthyl group or a substituted or unsubstituted fluorenyl group, provided that $Ar^{106}$ and $Ar^{301}$ are different.

Even if they have the same structure, $Ar^{106}$ and $Ar^{301}$ are different when their bonding positions to the anthracene are different.

Regarding the aromatic amine derivative represented by formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group.

The electron-attracting group in formula (1) is a group having a function of decreasing the electron density. Examples thereof include a cyano group, a fluorine atom, an alkyl halide group, a nitro group and a carbonyl group. Of these, a cyano group, a fluorine atom and an alkyl halide group are preferable and a cyano group is particularly preferable. It is supposed that long lifetime of a device can be realized by trapping extra electrons with the electron-attracting group to prevent electrons from intruding into a hole transforming material, whereby deterioration of the hole transforming material can be prevented.

In the invention, the aromatic amine derivative represented by formula (1) is preferably represented by the following formula (2):

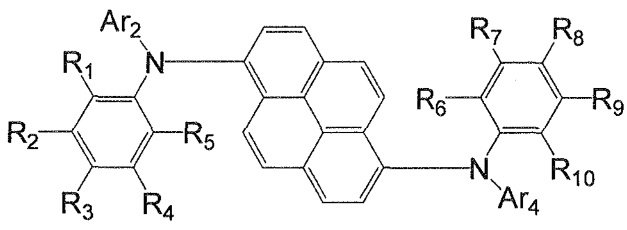

(2)

In formula (2), $Ar_2$ and $Ar_4$ are the same as those in formula (1).

$R_1$ to $R_{10}$ are independently a hydrogen atom, a halogen atom, a substituted or unsubstituted alkyl group having 1 to 20 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aralkyl group having 6 to 20 ring carbon atoms, a substituted or unsubstituted aryl group having 6 to 10. ring carbon atoms, or an electron-attracting group.

At least one of $R_1$ to $R_5$ is an electron-attracting group and at least one of $R_6$ to $R_{10}$ is an electron-attracting group. $Ar^2$ and $Ar^4$ may or may not have an electron-attracting group.

In formula (2), it is preferable that one of $R_1$ to $R_5$ be an electron-attracting group and the other groups be a hydrogen atom, and that one of $R_6$ to $R_{10}$ be an electron-attracting group and the other groups be a hydrogen atom.

In the description, the "ring carbon atoms" means carbon atoms that form a saturated ring, unsaturated ring or aromatic ring. The "ring atoms" means carbon atoms and hetero atoms that form a hetero ring (including a saturated ring, unsaturated ring or aromatic ring).

Examples of substituents in "substituted or unsubstituted..." include an alkyl group, alkylsilyl group, alkyl halide group, aryl group, cycloalkyl group, alkoxy group, heterocyclic group, aralkyl group, aryloxy group, arylthio group, alkoxycarbonyl group, halogen atom, hydroxyl group, nitro group, cyano group, carboxy group, dibenzofuranyl group and fluorenyl group as described below.

The hydrogen atom of the invention includes light hydrogen and deuterium.

Specific examples of the groups in formulas (1) and (2), and the substituents are shown below.

Examples of the alkyl group include a methyl group, ethyl group, propyl group, isopropyl group, n-butyl group, s-butyl group, isobutyl group, t-butyl group, n-pentyl group, n-hexyl group, n-heptyl group and n-octyl group.

The alkyl group preferably has 1 to 10 carbon atoms, more preferably 1 to 8 carbon atoms, and further preferably 1 to 6 carbon atoms. Of these, a methyl group, ethyl group, propyl group, isopropyl group, n-butyl group, s-butyl group, isobutyl group, t-butyl group, n-pentyl group and n-hexyl group are preferable.

The alkylsilyl group is represented by $-SiY_3$, and examples of Y are the same as those of the alkyl group.

Examples of the aryl group include a phenyl group, naphthyl group, anthryl group, 1-phenanthryl group, phenanthryl group, naphthacenyl group, pyrenyl group, chrysenyl group, benzo[c]phenanthryl group, benzo[g]chrysenyl group, triphenylenyl group, fluorenyl group, benzofluorenyl group, dibenzofluorenyl group, biphenylyl group, p-terphenyl-4-yl group, p-terphenyl-3-yl group, p-terphenyl-2-yl group, m-terphenyl-4-yl group, m-terphenyl-3-yl group, and m-terphenyl-2-yl group.

The aryl group has preferably 6 to 20, more preferably 6 to 14, further preferably 6 to 10 ring carbon atoms. Preferable aryl groups are a phenyl group and a naphthyl group.

The arylsilyl group is represented by $-SiZ_3$, and examples of Z are the same as those of the aryl group.

The alkoxy group is represented by -OY, and examples of Y are the same as those of the alkyl or aryl group.

The aralkyl group is represented by -Y-Z, examples of Y include alkylene groups corresponding to the examples of the alkyl group, and examples of Z are the same as those of the aryl group.

Examples of the cycloalkyl group include a cyclopropyl group, cyclobutyl group, cyclopentyl group, cyclohexyl group, 4-methylcyclohexyl group, 1-adamantyl group, 2-adamantyl group, 1-norbornyl group and 2-norbornyl group.

The cycloalkyl group has preferably 3 to 10 ring carbon atoms, more preferably 3 to 8 ring carbon atoms, and further preferably 3 to 6 ring carbon atoms.

Specific examples of the aromatic amine derivatives are given below.

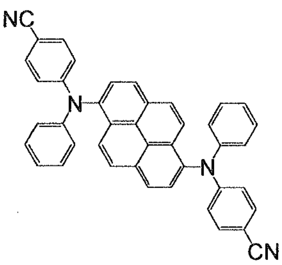

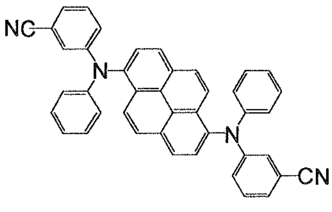

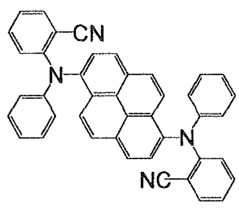

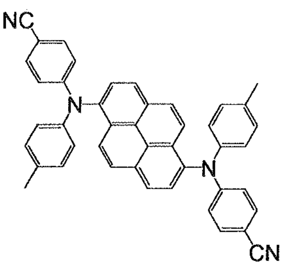

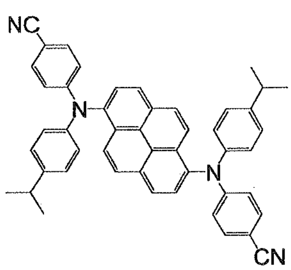

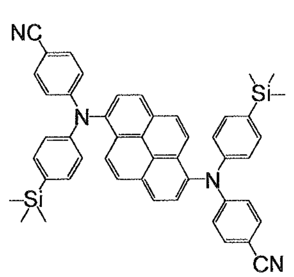

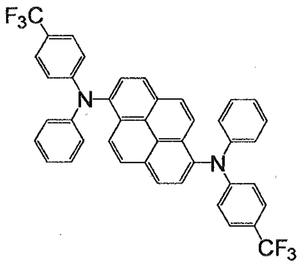
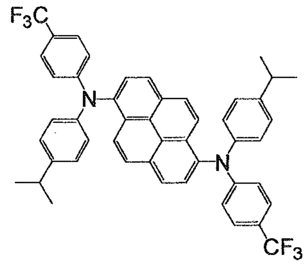
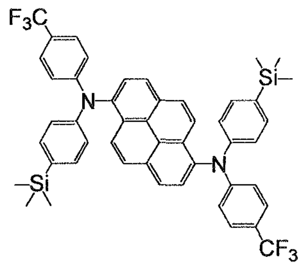

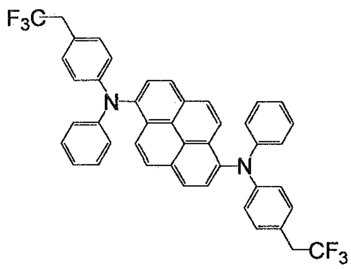
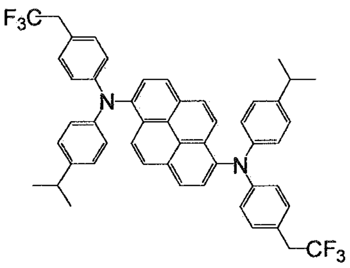
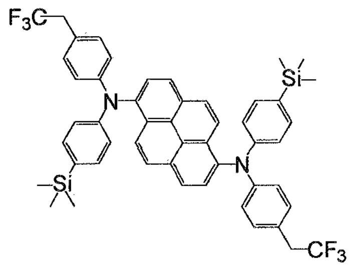

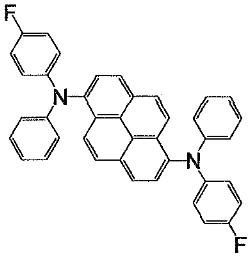
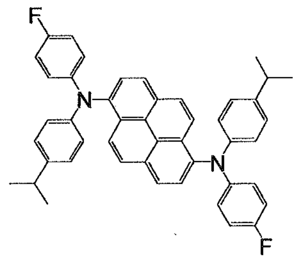
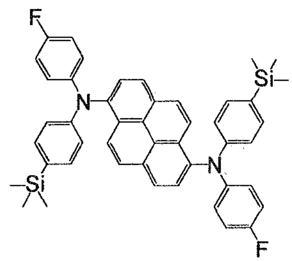

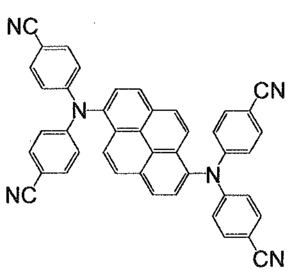
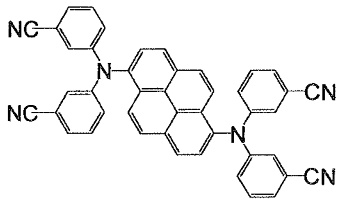
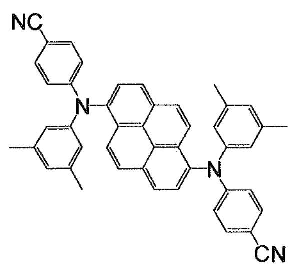

The organic luminescent medium of the invention comprises an aromatic amine derivative represented by the following formula (1) and an anthracene derivative represented by the following formula (10):

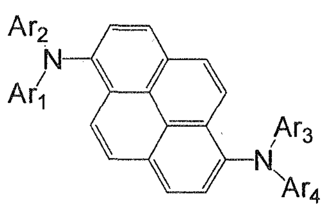
(1)

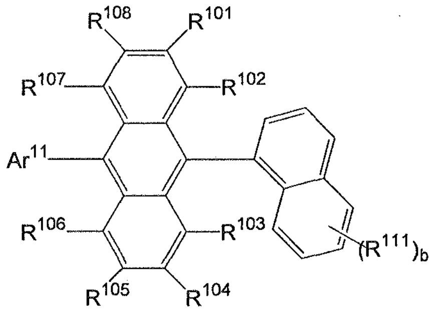

(10)

In the formula, $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms, or a substituted or unsubstituted heterocyclic group having 5 to 30 ring atoms,
$Ar^{11}$ is a substituted or unsubstituted phenyl group, substituted or unsubstituted 2-naphthyl group or a substituted or unsubstituted heterocyclic group having 5 to 30 ring atoms,
$R^{111}$ is a substituted or unsubstituted aryl group having 6 to 30 ring carbon atoms, a substituted or unsubstituted heterocyclic group having 5 to 30 ring atoms, a substituted or unsubstituted alkyl group having 1 to 10 carbon atoms, a substituted or unsubstituted cycloalkyl group having 3 to 10 ring carbon atoms, a substituted or unsubstituted alkoxy group having 1 to 20 carbon atoms, a substituted or unsubstituted silyl group, a cyano group or a fluorine atom, and
b is an integer of 0 to 7, and plural $R^{111}$s may be the same or different when b is an integer of 2 or more.

For example, $Ar^{11}$ is a phenyl group substituted by a substituted or unsubstituted aryl group having 6 to 30 ring carbon atoms or a substituted or unsubstituted heterocyclic group having 5 to 30 ring atoms, a 2-naphthyl group substituted by a substituted or unsubstituted aryl group having 6 to 30 ring carbon atoms or a substituted or unsubstituted heterocyclic group having 5 to 30 ring atoms, or a heterocyclic group having 5 to 30 ring atoms substituted by a substituted or unsubstituted aryl group having 6 to 30 ring carbon atoms or a substituted or unsubstituted heterocyclic group having 5 to 30 ring atoms.

For example, $Ar^{11}$ is a substituted or unsubstituted fused heterocyclic group having 10 to 30 ring atoms.

For example, $Ar^{11}$ is a substituted or unsubstituted 2-naphthyl group.

Of the anthracene derivatives represented by the formula (10), an anthracene derivative represented by the following formula (11) is preferable:

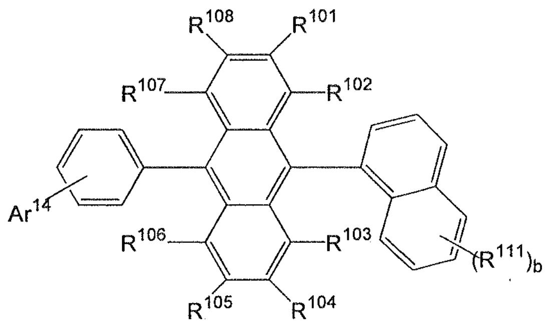

(11)

wherein $R^{101}$ to $R^{108}$, $R^{111}$ and b are the same as those in formula (10), and
$Ar^{14}$ is a substituted or unsubstituted aryl group having 6 to 30 ring carbon atoms, a substituted or unsubstituted alkyl group having 1 to 10 carbon atoms, a substituted or unsubstituted cycloalkyl group having 3 to 10 ring carbon atoms or a substituted or unsubstituted heterocyclic group having 5 to 30 ring atoms.
As $Ar^{14}$ , a 9,9-dimethylfluorene-1-yl group, a 9,9-dimethylfluorene-2-yl group, a 9,9-dimethylfluorene-3-yl group, a 9,9-dimethylfluorene-4-yl group, a dibenzofuran-1-yl group, a dibenzofuran-2-yl group, a dibenzofuran-3-yl group, and a dibenzofuran-4-yl group are also preferable.

For example, $Ar^{14}$ is a substituted or unsubstituted aryl group having 6 to 30 ring carbon atoms or a substituted

or unsubstituted heterocyclic group having 5 to 30 ring atoms.

The anthracene derivative may be one of the anthracene derivatives represented by the following formulas (12) to (18) in addition to those represented by formula (10).

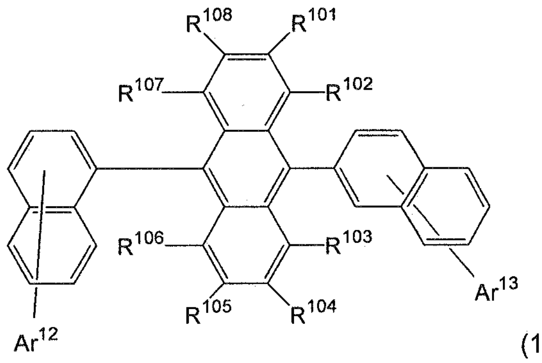

(12)

In the formula, $R^{101}$ to $R^{108}$ are the same as those in formula (10),
$Ar^{12}$ and $Ar^{13}$ are independently a hydrogen atom, an aryl group having 6 to 30 ring carbon atoms, or a substituted or unsubstituted heterocyclic group having 5 to 30 ring atoms, and $Ar^{12}$ may form a ring with the naphthalene ring to which $Ar^{12}$ bonds.

For example, $Ar^{12}$ or $Ar^{13}$ is a substituted or unsubstituted aryl group having 6 to 30 ring carbon atoms or a substituted or unsubstituted heterocyclic group having 5 to 30 ring atoms.
For example, $Ar^{12}$ forms a ring with the naphthalene ring to which $Ar^{12}$ bonds, and the ring is a substituted or unsubstituted fused heterocyclic group having 10 to 30 ring atoms.
For example, $Ar^{13}$ is a hydrogen atom.

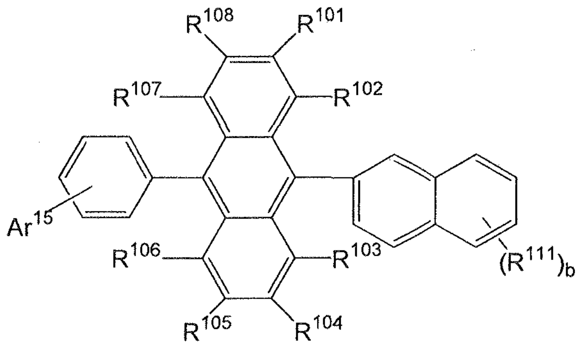

(13)

In the formula, $R^{101}$ to $R^{108}$, $R^{111}$ and b are the same as those in formula (10),
$Ar^{15}$ is a substituted or unsubstituted aryl group having 6 to 30 ring carbon atoms, a substituted or unsubstituted alkyl group having 1 to 10 carbon atoms, a substituted or unsubstituted cycloalkyl group having 3 to 10 ring carbon atoms or a substituted or unsubstituted heterocyclic group having 5 to 30 ring atoms.
For example, $Ar^{15}$ is preferably a dibenzofuran-1-yl group, a dibenzofuran-2-yl group, a dibenzofuran-3-yl group, or a dibenzofuran-4-yl group.

For example, $Ar^{15}$ is a substituted or unsubstituted aryl group having 6 to 30 ring carbon atoms or a heterocyclic group having 5 to 30 ring atoms.

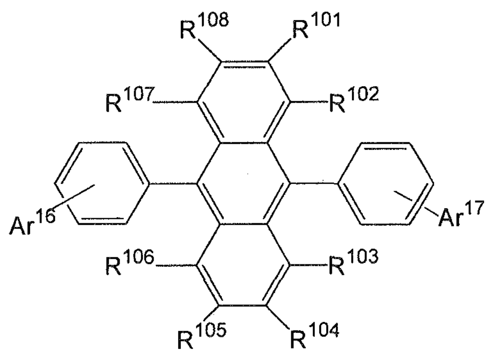

(14)

In the formula, $R^{101}$ to $R^{108}$ are the same as those in formula (10),
$Ar^{16}$ is a substituted or unsubstituted aryl group having 6 to 30 ring carbon atoms, a substituted or unsubstituted alkyl group having 1 to 10 carbon atoms, a substituted or unsubstituted cycloalkyl group having 3 to 10 ring carbon atoms or a substituted or unsubstituted heterocyclic group having 5 to 50 ring atoms, and $Ar^{16}$ may form a ring with the benzene ring to which $Ar^{16}$ bonds, and
$Ar^{17}$ is a substituted or unsubstituted aryl group having 6 to 30 ring carbon atoms, a substituted or unsubstituted alkyl group having 1 to 10 carbon atoms, a substituted or unsubstituted cycloalkyl group having 3 to 10 ring carbon atoms or a substituted or unsubstituted heterocyclic group having 5 to 30 ring atoms.

For example, $Ar^{16}$ or $Ar^{17}$ is a substituted or unsubstituted aryl group having 6 to 30 ring carbon atoms or a heterocyclic group having 5 to 30 ring atoms.
For example, $Ar^{16}$ forms a ring with the benzene ring to which $Ar^{16}$ bonds, and the ring is a substituted or unsubstituted fused heterocyclic group having 10 to 30 ring atoms.
For example, $Ar^{16}$ forms a ring with the benzene ring to which $Ar^{16}$ bonds, and the ring is a substituted or unsubstituted 2-naphthyl group.

As the anthracene derivative of formula (14), the structures represented by the following formulas (14-1) to (14-3) are preferable.

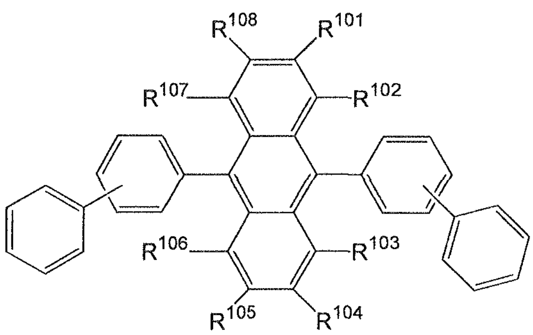

(14-1)

In formula (14-1), $R^{101}$ to $R^{108}$ are the same as those described above.

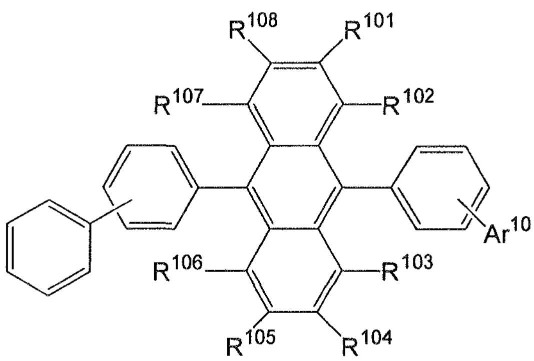

(14-2)

In formula (14-2), $R^{101}$ to $R^{108}$ are the same as those in the formula (10). $Ar^{10}$ is a substituted or unsubstituted

fused aromatic ring group having 10 to 20 ring carbon atoms.

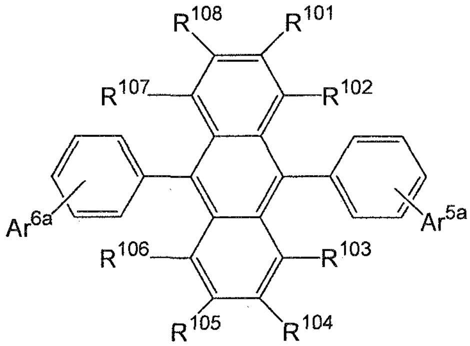

(14-3)

In formula (14-3), $R^{101}$ to $R^{108}$ are the same as those described above. $Ar^{5a}$ and $Ar^{6a}$ are independently a substituted or unsubstituted fused aromatic ring group having 10 to 20 ring carbon atoms.

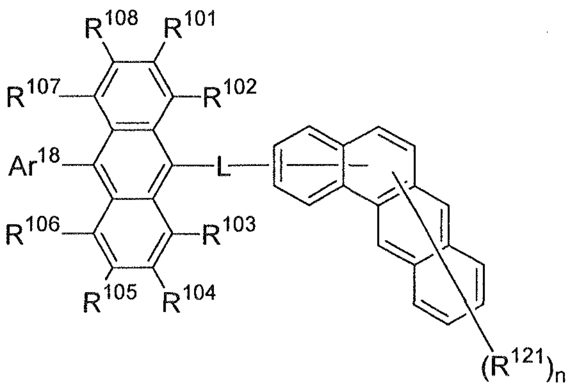

(15)

In the formula, $R^{101}$ to $R^{108}$ are the same as those in formula (10),
$Ar^{18}$ is a substituted or unsubstituted aryl group having 6 to 30 ring carbon atoms or a substituted or unsubstituted heterocyclic group having 5 to 30 ring atoms,
L is a single bond, a substituted or unsubstituted arylene group having 6 to 30 ring carbon atoms or a substituted or unsubstituted divalent heterocyclic group having 5 to 30 ring atoms,
$R^{121}$ is a substituted or unsubstituted aryl group having 6 to 30 ring carbon atoms, a substituted or unsubstituted heterocyclic group having 5 to 30 ring atoms, a substituted or unsubstituted alkyl group having 1 to 10 carbon atoms, a substituted or unsubstituted cycloalkyl group having 3 to 10 ring carbon atoms, a substituted or unsubstituted alkoxy group having 1 to 20 carbon atoms, a substituted or unsubstituted silyl group, a cyano group or a fluorine atom, and
n is an integer of 0 to 11, and plural $R^{121}$s may be the same or different when n is an integer of 2 or more.

For example, when L is a single bond, $Ar^{18}$ is an aryl group having 6 to 30 ring carbon atoms or a heterocyclic group having 5 to 30 ring atoms which is substituted by an aryl group having 6 to 30 ring carbon atoms or a heterocyclic group having 5 to 30 ring atoms.
For example, L is a single bond.

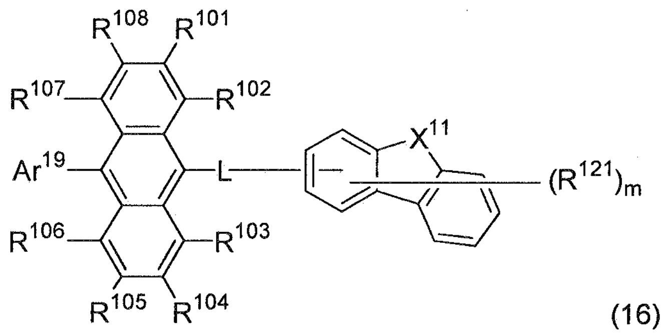

(16)

In the formula, $R^{101}$ to $R^{108}$ are the same as those in formula (10),
L is a single bond, a substituted or unsubstituted arylene group having 6 to 50 ring carbon atoms or a substituted or unsubstituted divalent heterocyclic group having 5 to 50 ring atoms,
$Ar^{19}$ is a substituted or unsubstituted aryl group having 6 to 30 ring carbon atoms or a substituted or unsubstituted heterocyclic group having 5 to 30 ring atoms,
$X^{11}$ is an oxygen atom, a sulfur atom, -NR- or $-CR^aR^b$ wherein R, $R^a$ and $R^b$ are the same group as those in $R^{101}$ to $R^{108}$,
$R^{121}$ is a substituted or unsubstituted aryl group having 6 to 30 ring carbon atoms or a substituted or unsubstituted heterocyclic group having 5 to 30 ring atoms, a substituted or unsubstituted alkyl group having 1 to 10 carbon atoms, a substituted or unsubstituted cycloalkyl group having 3 to 10 ring carbon atoms, a substituted or unsubstituted alkoxy group having 1 to 20 carbon atoms, a substituted or unsubstituted silyl group, a cyano group or a fluorine atom, and
m is an integer of 0 to 7, and plural $R^{121}$s may be the same or different when m is an integer of 2 or more.

For example, when L is a single bond, $Ar^{19}$ is an aryl group having 6 to 30 ring carbon atoms or a heterocyclic group having 5 to 30 ring atoms which is substituted by an aryl group having 6 to 30 ring carbon atoms or a heterocyclic group having 5 to 30 ring atoms.

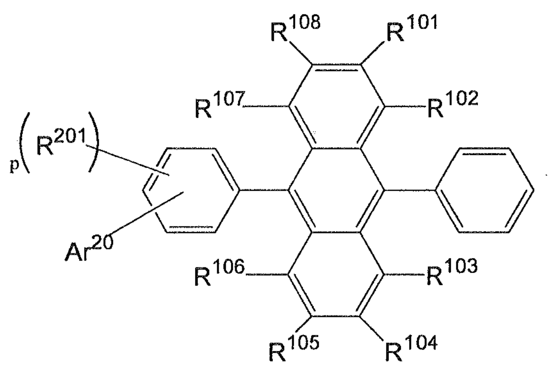

(17)

In formula (17), $R^{101}$ to $R^{108}$ are the same as those in formula (10),
$Ar^{201}$ is a substituted or unsubstituted aryl group having 6 to 30 ring carbon atoms or a substituted or unsubstituted heterocyclic group having 5 to 30 ring atoms,
$R^{201}$ is a substituted or unsubstituted aryl group having 6 to 30 ring carbon atoms, a substituted or unsubstituted heterocyclic group having 5 to 30 ring atoms, a substituted or unsubstituted alkyl group having 1 to 10 carbon atoms, a substituted or unsubstituted cycloalkyl group having 3 to 10 ring carbon atoms, a substituted or unsubstituted alkoxy group having 1 to 20 carbon atoms, a substituted or unsubstituted silyl group, a cyano group or a fluorine atom, and
p is an integer of 0 to 4, and plural $R^{201}$s may be the same or different when p is an integer of 2 or more.

For example, $Ar^{20}$ is an aryl group having 6 to 30 ring carbon atoms or a heterocyclic group having 5 to 30 ring atoms which is substituted by an aryl group having 6 to 30 ring carbon atoms or a heterocyclic group having 5 to 30 ring atoms.

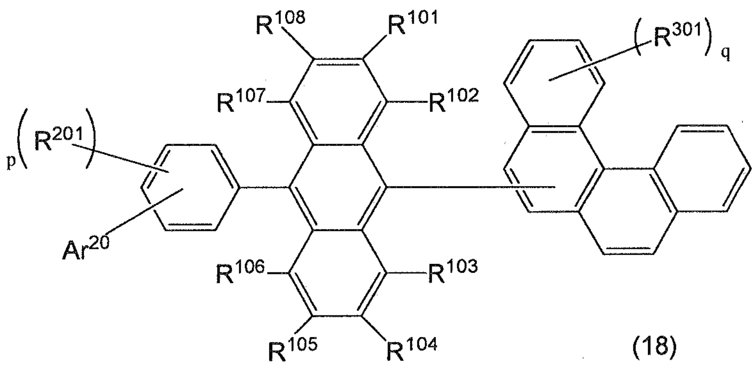

(18)

In formula (18), $R^{101}$ to $R^{108}$ are the same as those in formula (10),
$Ar^{20}$ and $R^{201}$ are the same as those in formula (17),
$R^{301}$ is a substituted or unsubstituted aryl group having 6 to 30 ring carbon atoms or a substituted or unsubstituted heterocyclic group having 5 to 30 ring atoms, a substituted or unsubstituted alkyl group having 1 to 10 carbon atoms, a substituted or unsubstituted cycloalkyl group having 3 to 10 ring carbon atoms, a substituted or unsubstituted alkoxy group having 1 to 20 carbon atoms, a substituted or unsubstituted silyl group, a cyano group or a fluorine atom,
p is an integer of 0 to 4, and plural $R^{201}$s may be the same or different when p is an integer of 2 or more,
q is an integer of 0 to 11, plural $R^{301}$s may be the same or different when q is an integer of 2 or more, and
adjacent substituents may form a saturated or unsaturated ring.

Examples of the aryl group having 6 to 30 ring carbon atoms of $R^{101}$ to $R^{108}$, $R^{111}$, $R^{121}$, $R^{201}$, $R^{301}$, $Ar^{12}$ to $Ar^{20}$ and $Ar^{101}$ to $Ar^{106}$ include a phenyl group, naphthyl group, anthryl group, phenanthryl group, naphthacenyl group, pyrenyl group, chrysenyl group, benzo[c]phenanthryl group, benzo[g]chrysenyl group, benzo[a]anthryl group, triphenylenyl group, fluorenyl group, 9,9-dimethylfluorene-2-yl group, benzofluorenyl group, dibenzofluorenyl group, biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, and 4"-t-butyl-p-terphenyl-4-yl group. The aryl group preferably has 6 to 20 ring carbon atoms, more preferably 6 to 14 ring carbon atoms and further preferably 6 to 10 ring carbon atoms.

Of these, an unsubstituted phenyl group, substituted phenyl group, substituted or unsubstituted aryl group having 10 to 14 ring carbon atoms (for example, a 1-naphthyl group, 2-naphthyl group and 9-phenanthryl group), substituted or unsubstituted fluorenyl group (2-fluorenyl group), and substituted or unsubstituted pyrenyl group (1-pyrenyl group, 2-pyrenyl group, and 4-pyrenyl group) are preferable.
The aryl group having 6 to 30 ring carbon atoms may be substituted by a substituent such as an alkyl group, cycloalkyl group, aryl group and heterocyclic group, and examples of the substituent include the same groups as the above-mentioned substituents. As the substituent, an aryl group and heterocyclic group are preferable.

Examples of the fused aromatic ring group having 10 to 20 ring carbon atoms of $Ar^{5a}$, $Ar^{6a}$ and $Ar^{10}$ include a 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group and 2-fluorenyl group. In particular, 1-naphthyl group, 2-naphthyl group, 9-phenanthryl group, and fluorenyl group (2-fluorenyl group) are preferable.
Examples of the fused aromatic ring group of $Ar^{201}$ having 16 to 30 ring carbon atoms include triphenylenyl group, pyrenyl group, chrysenyl group, benzo[c]phenanthryl group and benzo[g]chrysenyl group. In particular, benzo[c]phenanthryl group, benzo[g]chrysenyl group are preferable.

The fused aromatic ring group may be substituted by a substituent such as an alkyl group, cycloalkyl group, aryl group and heterocyclic group, and examples of the substituent include the same groups as the above-mentioned substituents. As the substituent, an aryl group and heterocyclic group are preferable.

Examples of the heterocyclic group having 5 to 30 ring atoms of $R^{101}$ to $R^{108}$, $R^{111}$, $Ar^{12}$ to $Ar^{20}$ and $Ar^{101}$ to $Ar^{106}$ include a pyrrolyl group, pyrazinyl group, pyridinyl group, indolyl group, isoindolyl group, furyl group, benzofuranyl group, isobenzofuranyl group, dibenzofuranyl group, dibenzothiophenyl group, quinolyl group, isoquinolyl group, quinoxalinyl group, carbazolyl group, phenanthrydinyl group, acridinyl group, phenanthronyl group, phenazinyl group, phenothiazinyl group, phenoxazinyl group, oxazolyl group, oxadiazolyl group, furazanyl group, thienyl group, methylpyrrolyl group, 2-t-butylpyrrolyl group, 3-(2-phenylpropyl)pyrrolyl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group and 4-t-butyl-3-indolyl group. Of these, dibenzofuranyl group, dibenzothiophenyl group and carbazolyl group are preferable.

Examples of the fused heterocyclic group having 10 to 30 ring atoms of $Ar^{201}$ include a quinolyl group and dibenzofuranyl group, and dibenzofuranyl group is particularly preferable.
The heterocyclic group having 5 to 30 ring atoms may be substituted by a substituent such as an alkyl group, cycloalkyl group, aryl group and heterocyclic group, and examples of the substituent include the same groups as the above-mentioned substituents. As the substituent, an aryl group and heterocyclic group are preferable.

Examples of the alkyl group having 1 to 10 carbon atoms of $R^{101}$ to $R^{108}$, $R^{111}$, $R^{121}$, $R^{201}$, $R^{301}$, and $Ar^{14}$ to $Ar^{17}$ include a methyl group, ethyl group, propyl group, isopropyl group, n-butyl group, s-butyl group, isobutyl group, t-butyl group, n-pentyl group, n-hexyl group, n-heptyl group, n-octyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydroxypropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoathyl group, 2-cyanoethyl group, 2-cyanoisobutyl group, 1,2-dicyanoethyl group, 1,3-dicyanoisopropyl group, 2,3-dicyano-t-butyl group and 1,2,3-tricyanopropyl group. The alkyl group preferably has 1 to 10 carbon atoms, more preferably 1 to 8 carbon atoms, and further preferably 1 to 6 carbon atoms.
Of these, a methyl group, ethyl group, propyl group, isopropyl group, n-butyl group, s-butyl group, isobutyl group and t-butyl group are preferable. The alkyl group having 1 to 10 carbon atoms may be substituted by a substituent such as an alkyl group, cycloalkyl group, aryl group and heterocyclic group, and examples of the substituent include the same groups as the above-mentioned substituents. As the substituent, an aryl group and heterocyclic group are preferable.

Examples of the cycloalkyl group having 3 to 10 ring carbon atoms of $R^{101}$ to $R^{108}$, $R^{111}$, $R^{121}$ $R^{201}$, $R^{301}$, and $Ar^{14}$ to $Ar^{17}$ include a cyclopropyl group, cyclobutyl group, cyclopentyl group, cyclohexyl group, 4-methylcyclohexyl group, 1-adamantyl group, 2-adamantyl group, 1-norbornyl group and 2-norbornyl group. Of these, cyclopentyl and cyclohexyl are preferable. The cycloalkyl group preferably has 3 to 10 ring carbon atoms, more preferably 3 to 8 ring carbon atoms, and further preferably 3 to 6 ring carbon atoms. The cycloalkyl group having 3 to 10 ring carbon atoms may be substituted by a substituent such as an alkyl group, cycloalkyl group, aryl group and heterocyclic group, and examples of the substituent include the same groups as the above-mentioned substituents. As the substituent, an aryl group and heterocyclic group are preferable.

Examples of the alkylsilyl group and arylsilyl group of $R^{101}$ to $R^{108}$, $R^{111}$, $R^{121}$, $R^{201}$ and $R^{301}$ include a trimethylsilyl group, triethylsilyl group, t-butyldimethylsilyl group, vinyldimethylsilyl group, propyldimethylsilyl group and triphenylsilyl group. The silyl group may be substituted by a substituent such as an alkyl group, cycloalkyl group, aryl group and heterocyclic group, and examples of the substituent include the same groups as the above-mentioned substituents. As the substituent, an aryl group and heterocyclic group are preferable.

The alkoxy group having 1 to 20 carbon atoms of $R^{101}$ to $R^{108}$, $R^{111}$, $R^{121}$, $R^{201}$ and $R^{301}$ is represented by -OZ, and Z is selected from the substituted or unsubstituted alkyl group of $R^{101}$ to $R^{108}$. The alkyl group may be substituted by a substituent such as an alkyl group, cycloalkyl group, aryl group and heterocyclic group, and examples of the substituent include the same groups as the above-mentioned substituents. As the substituent, an aryl group and heterocyclic group are preferable.

The aryloxy group having 6 to 20 carbon atoms of $R^{101}$ to $R^{108}$, $R^{111}$, $R^{121}$, $R^{201}$ and $R^{301}$ is represented by -OZ, and Z is selected from the substituted or unsubstituted aryl group of $R^{101}$ to $R^{108}$. The aryl group may be substituted by a substituent such as an alkyl group, cycloalkyl group, aryl group and heterocyclic group, and examples of the substituent include the same groups as the above-mentioned substituents. As the substituent, an aryl group and heterocyclic group are preferable.

As the substituted or unsubstituted arylene group having 6 to 30 ring carbon atoms or the substituted or unsubstituted divalent heterocyclic group having 5 to 30 ring atoms of L in formulas (10-7) and (10-8), divalent groups of the aryl group and heterocyclic group described above can be given.

It appears that a device has a high efficiency and a long lifetime when an anthracene derivative having many (4 or more) aryl (arylene) groups which are bonded via single bonds between aryl groups such as the compound of formula (I) or an anthracene derivative having a fused aromatic ring group (4 rings or more) having 16 to 30 ring carbon atoms as an aryl group such as the compound of formula (II) is used, since host molecules becomes bigger in size and hence energy transfer to a dopant easily occurs.

It appears that a device has high efficiency and a long lifetime when an anthracene derivative having a fused heterocyclic group is used, since the ring lacks $\pi$ electrons, the anthracene derivative easily interacts with an electron-rich dopant having a tertiary amino group, and energy transfer tends to occur easily.

In addition, even in the case of a derivative having a small number (3) of aryl (arylene) groups which bonded via single bonds; i.e. in the case of a derivative in which the host molecule thereof is small such as a derivative of formula (III), if an anthracene as the main skeleton and an aryl group which directly bonds to the main skeleton, such as a $\beta$-naphthyl group or a fluorenyl group, have high planarity, a device has a high efficiency and a long lifetime. The reason therefor is that the part easily interacts with a dopant and energy transfer tends to occur easily. In particular, the above-mentioned effect can be easily obtained when an anthracene molecule becomes less symmetrical, since crystallization

hardly occurs to improve film properties.

The emission lifetime of a device can be improved by using the medium of the invention which is a combination of the aromatic amine derivative represented by formula (1) and the anthracene derivative represented by formulas (I), (II), (III) or (10) to (18). In addition, a device can emit blue light having a shorter wave length (for example, 460 nm or less) as compared with a conventional device if the aryl group of a diarylamino group has an electron-attracting group.

Specific examples of the anthracene derivative of the invention can be given as follows:

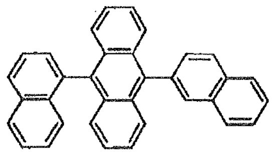

EM13

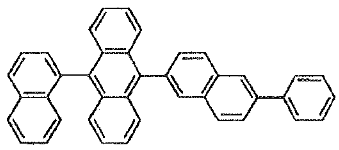

EM14

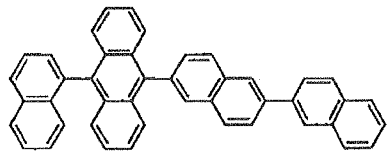

EM15

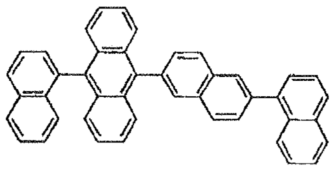

EM16

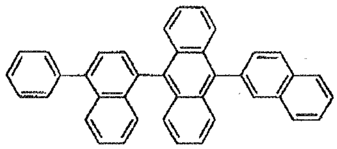

EM17

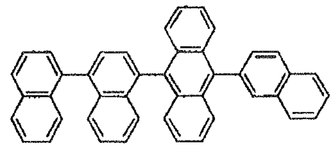

EM18

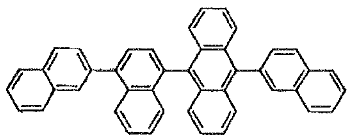

EM19

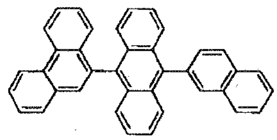

EM20

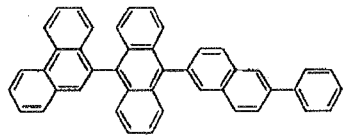

EM21

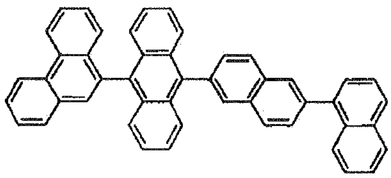

EM22

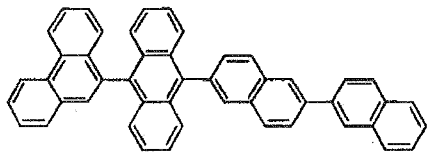

EM23

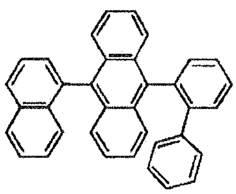

EM24

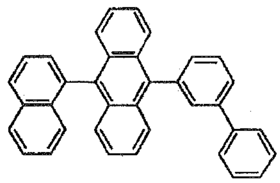

EM25

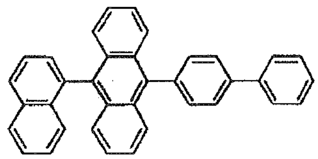

EM26

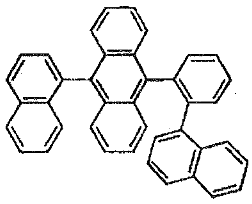

EM27

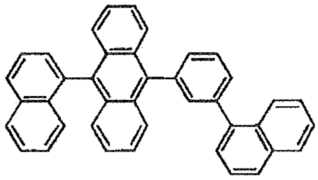

EM28

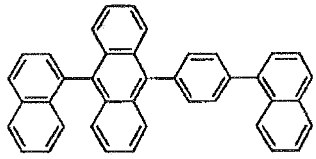

EM29

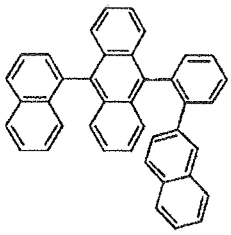

EM30

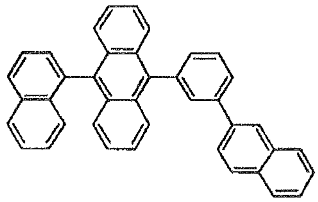

EM31

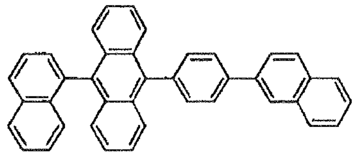

EM32

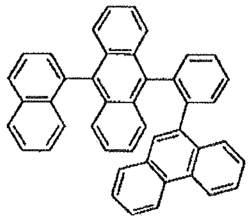

EM33

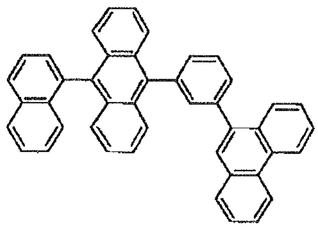

EM34

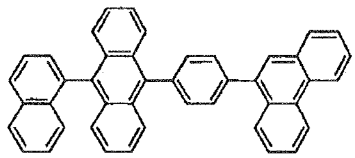

EM35

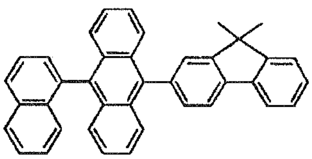

EM36

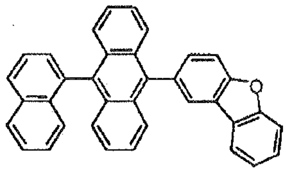

EM37

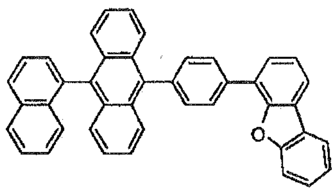

EM38

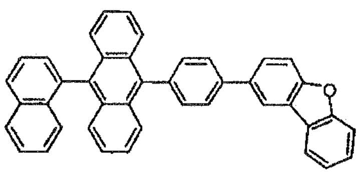

EM39

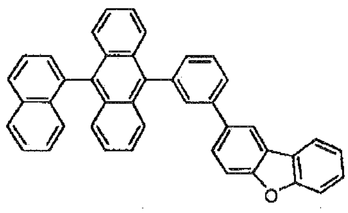

EM40

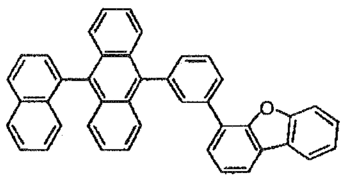

EM41

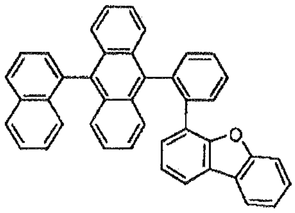

EM42

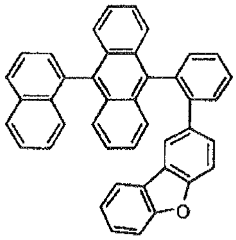

EM43

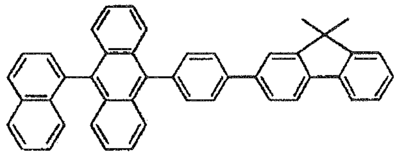

EM44

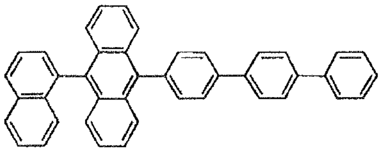

EM45

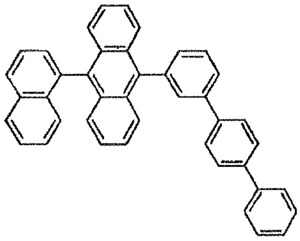

EM46

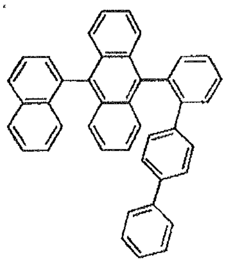

EM47

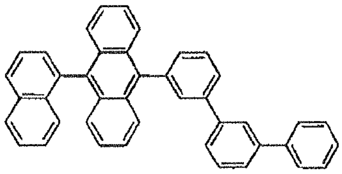

EM48

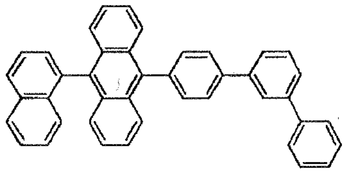

EM49

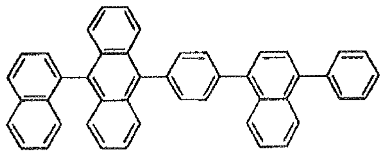

EM50

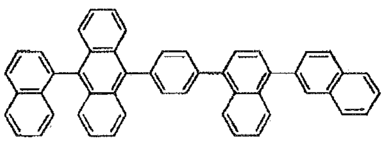

EM51

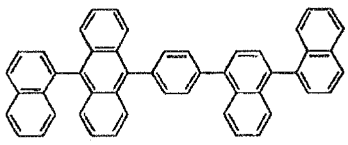

EM52

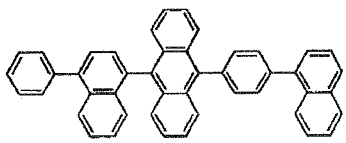

EM53

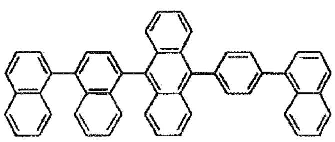

EM54

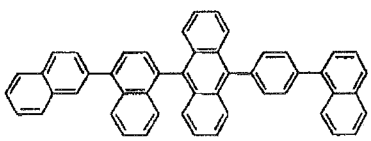

EM55

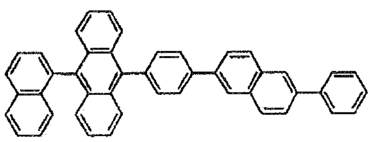

EM56

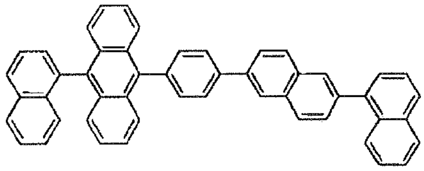

EM57

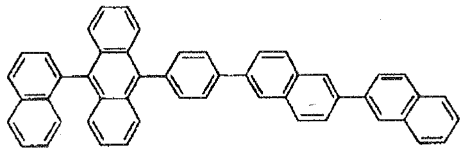

EM58

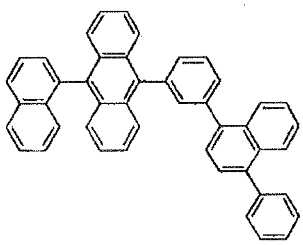

EM59

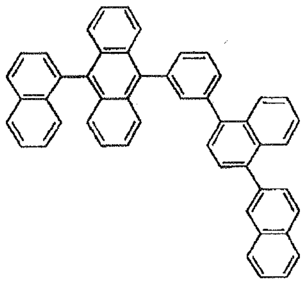

EM60

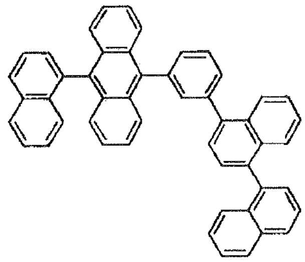

EM61

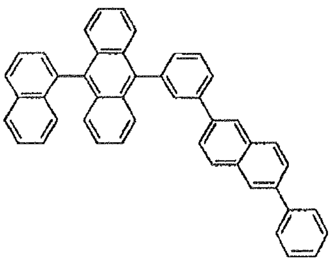

EM62

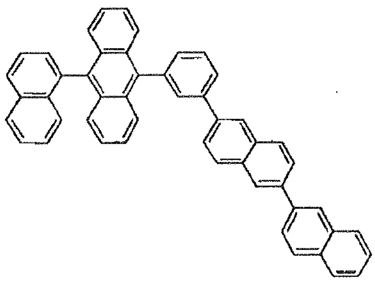

EM63

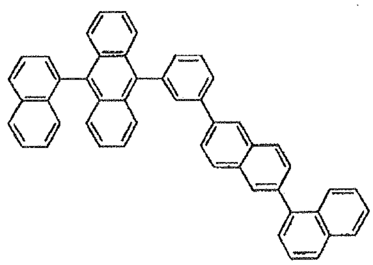

EM64

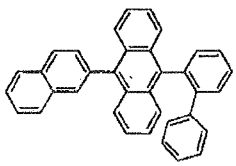

EM65

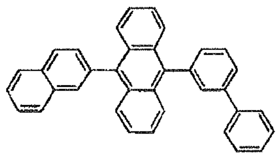

EM66

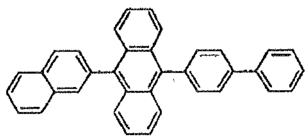

EM67

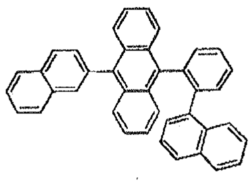

EM68

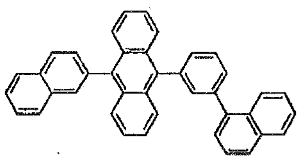

EM69

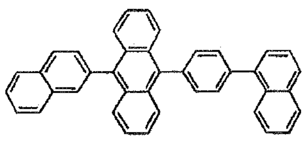

EM70

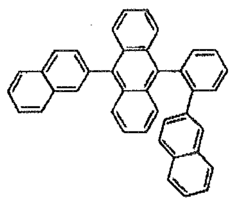

EM71

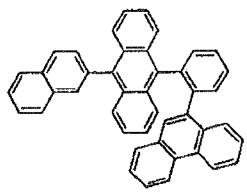

EM72

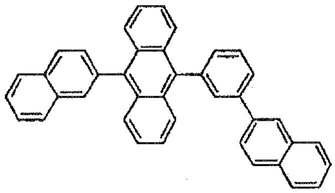
EM73

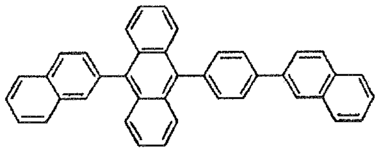
EM74

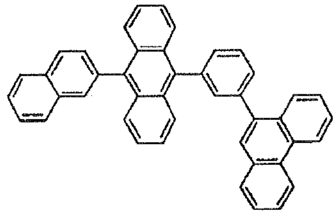
EM75

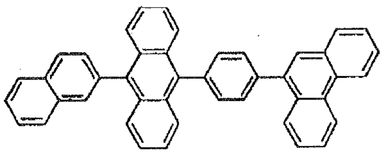
EM76

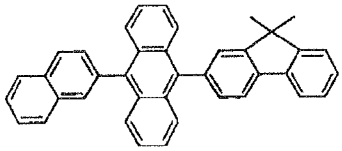
EM77

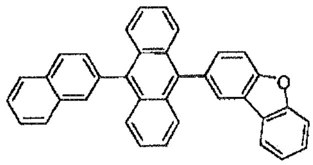
EM78

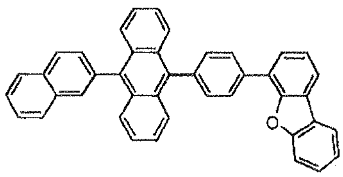
EM79

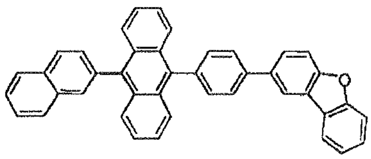
EM80

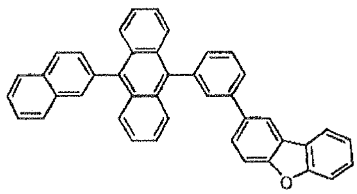
EM81

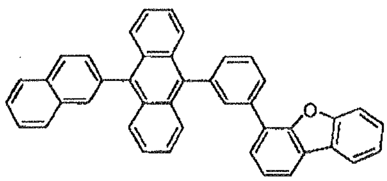
EM82

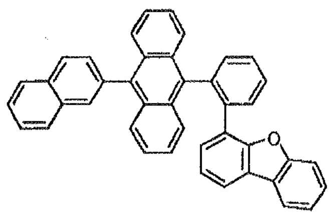
EM83

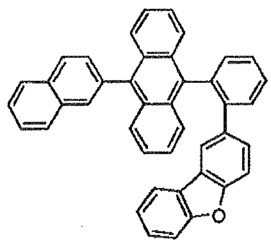
EM84

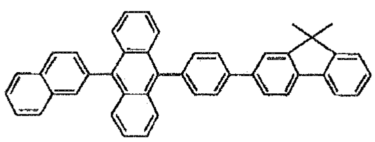
EM85

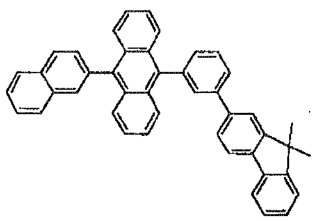
EM86

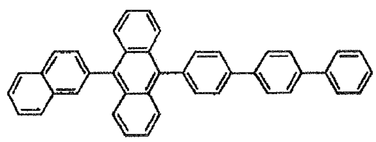
EM87

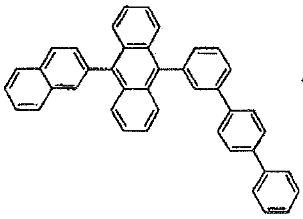

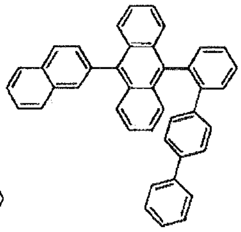

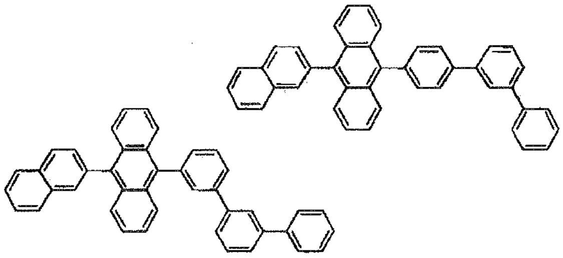

EM88 EM89 EM90 EM91

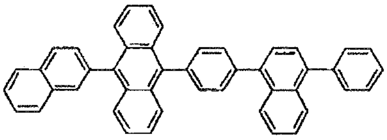

EM92

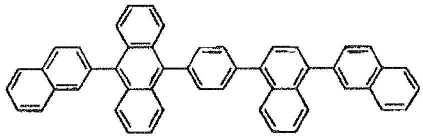

EM93

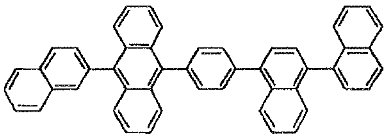

EM94

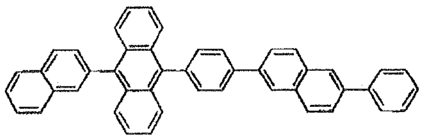

EM95

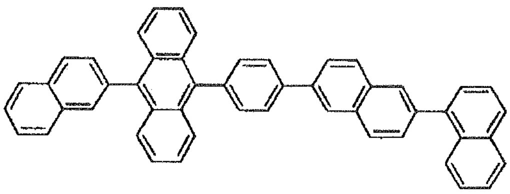

EM96

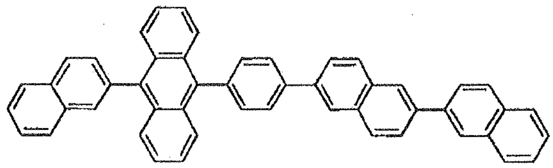

EM97

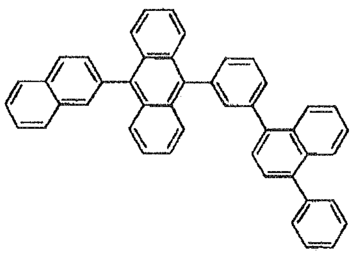

EM98

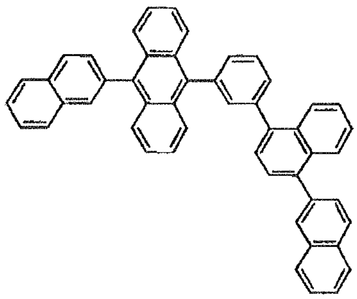

EM99

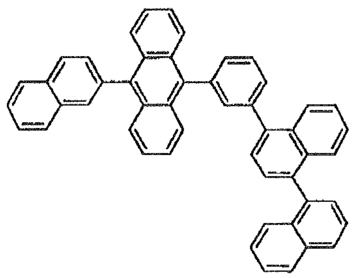

EM100

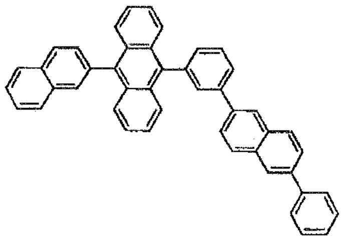

EM101

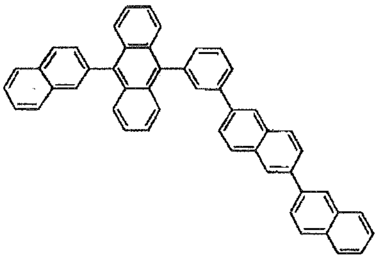

EM102

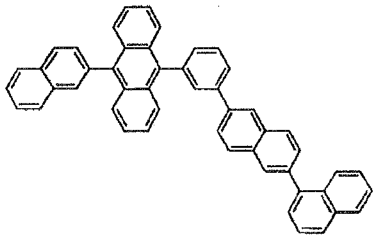

EM103

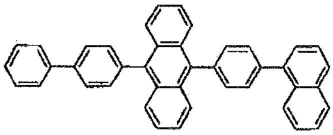

EM104

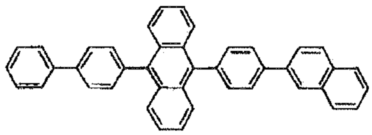

EM105

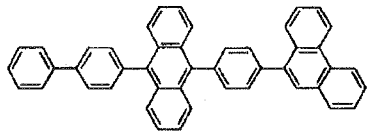

EM106

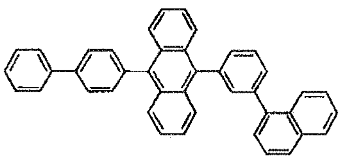

EM107

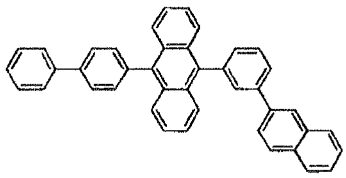

EM108

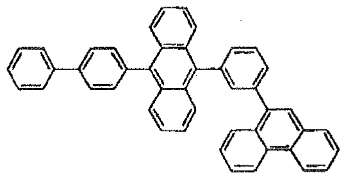

EM109

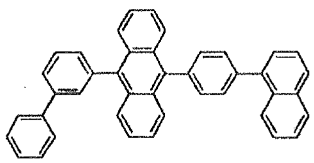

EM110

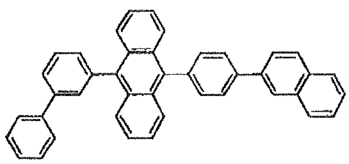

EM111

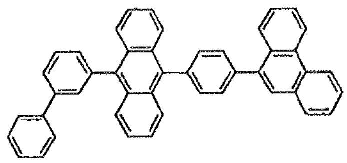

EM112

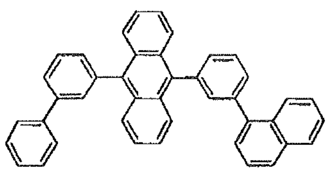

EM113

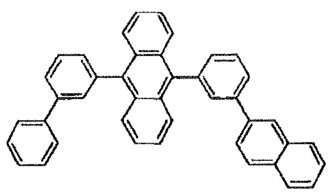

EM114

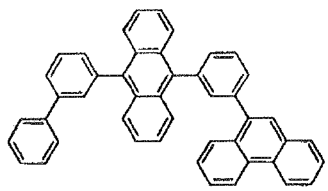

EM115

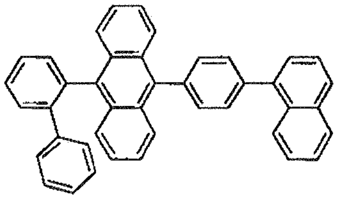
EM116

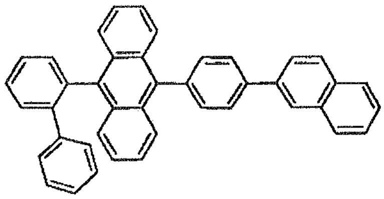
EM117

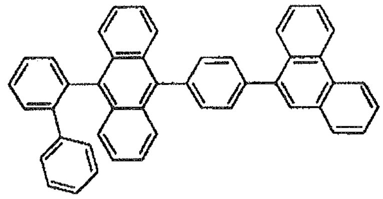
EM118

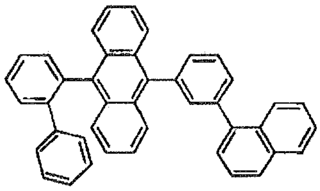
EM119

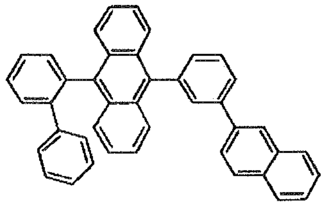
EM120

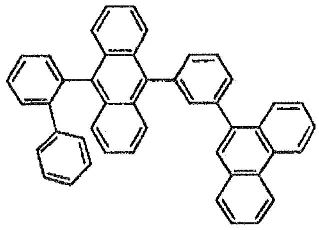
EM121

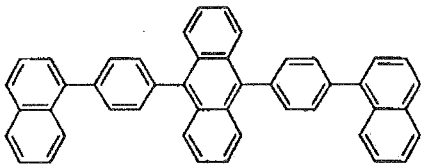
EM122

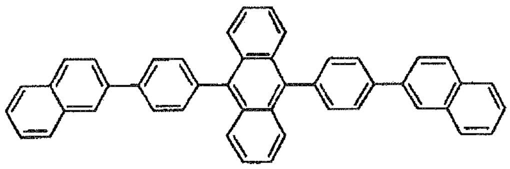
EM123

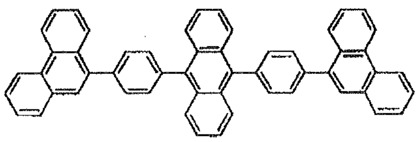
EM124

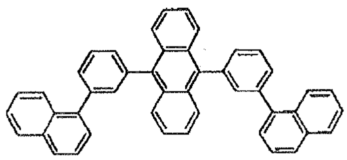
EM125

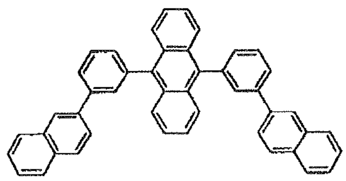
EM126

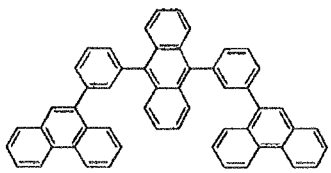
EM127

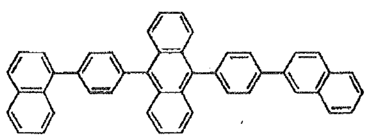
EM128

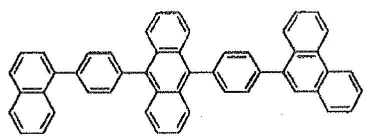
EM129

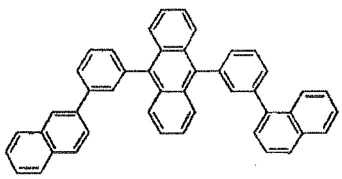
EM130

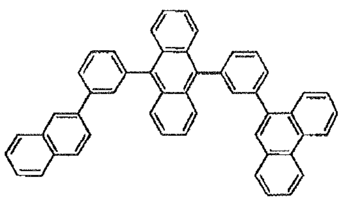
EM131

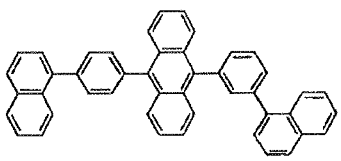
EM132

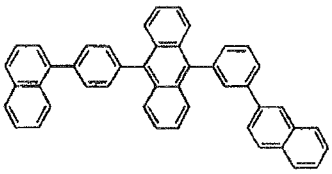

EM133

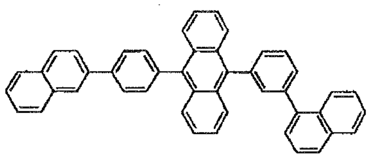

EM134

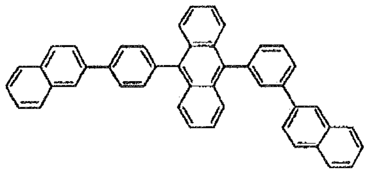

EM135

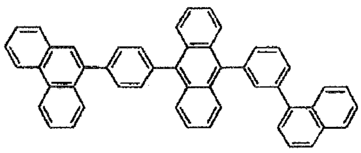

EM136

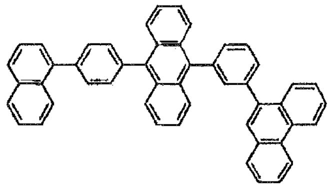

EM137

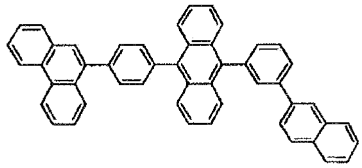

EM138

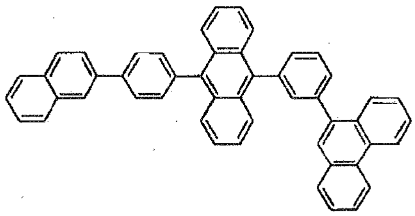

EM139

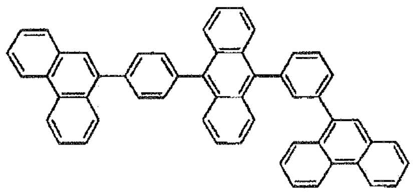

EM140

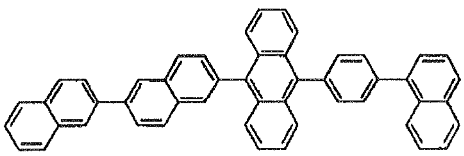

EM141

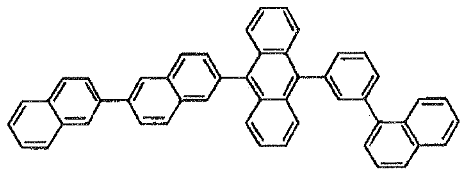

EM142

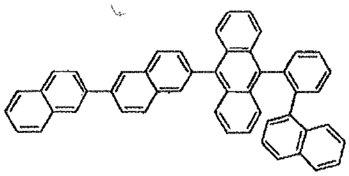

EM143

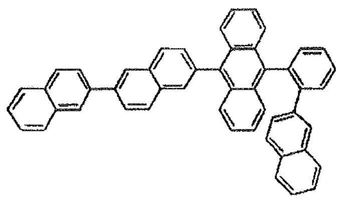

EM144

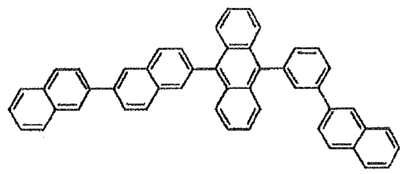

EM145

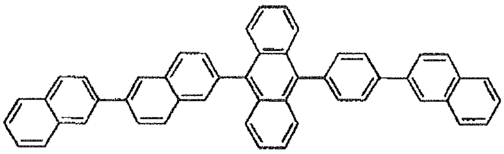

EM146

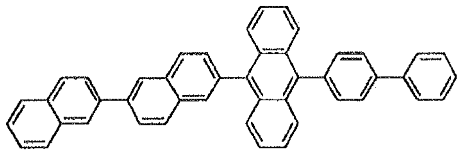

EM147

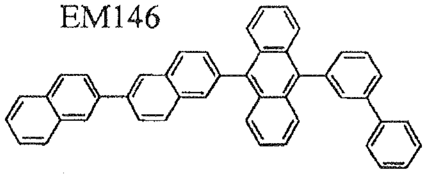

EM148

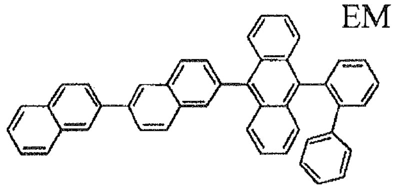

EM149

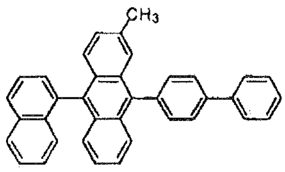

EM153

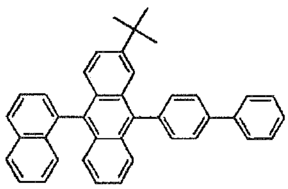

EM154

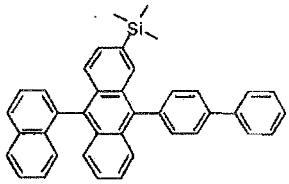

EM155

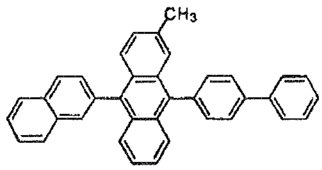

EM156

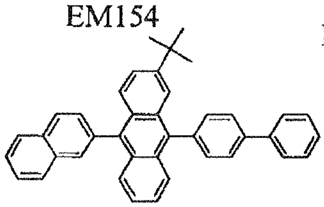

EM157

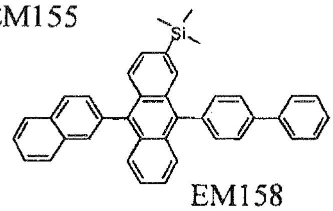

EM158

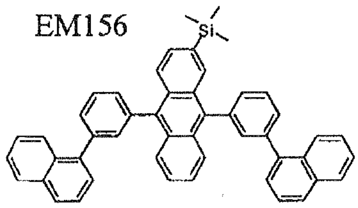

EM159

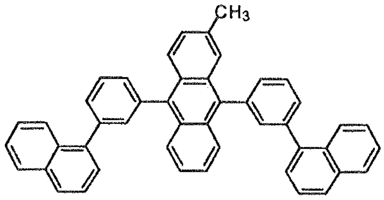

EM160

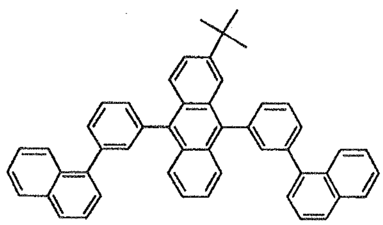

EM161

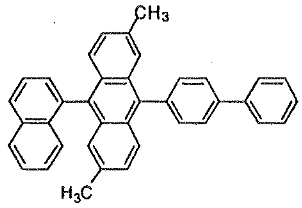

EM165

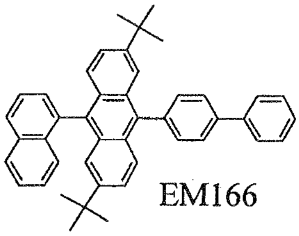

EM166

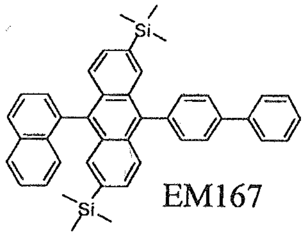

EM167

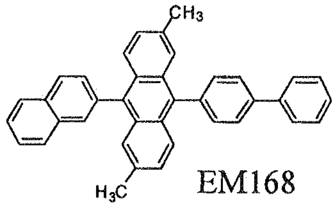

EM168

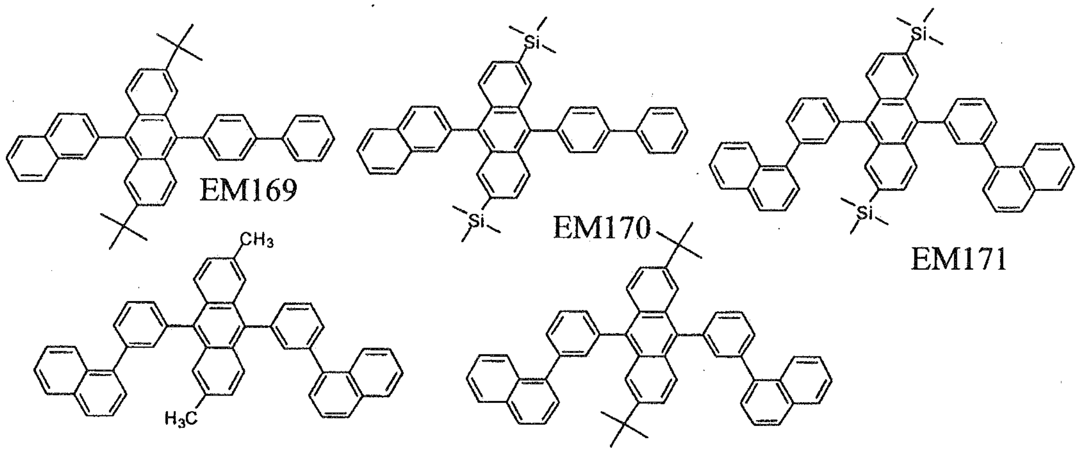

EM169 EM170 EM171

EM172 EM173

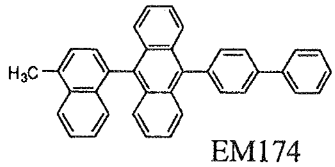

EM174

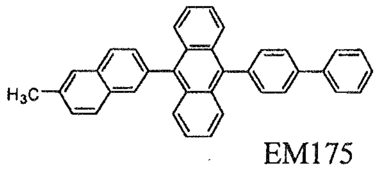

EM175

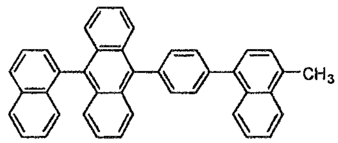

EM176

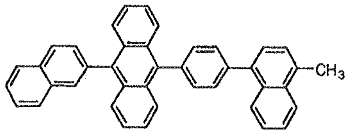

EM177

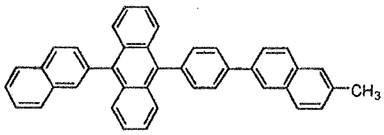

EM178

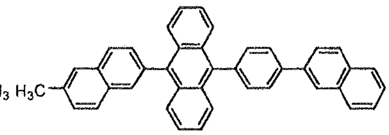

EM179

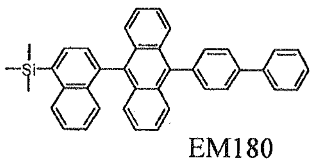

EM180

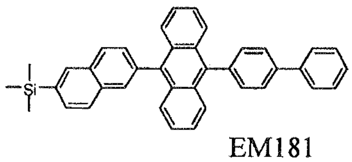

EM181

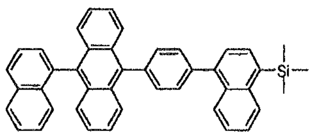

EM182

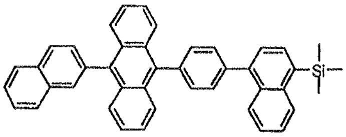

EM183

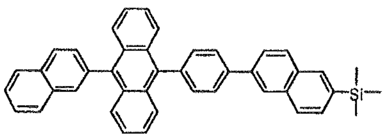

EM184

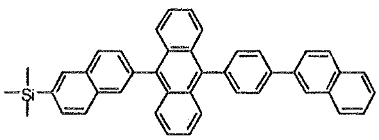

EM185

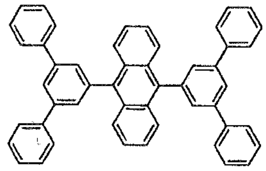

EM186

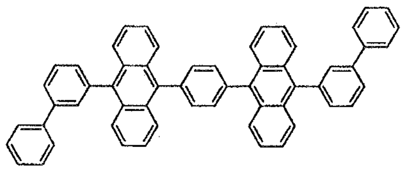

EM188

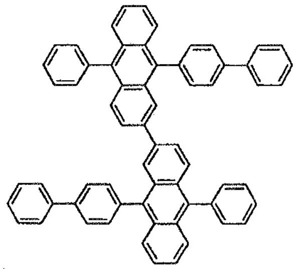

EM190

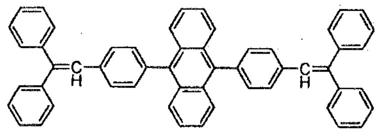

EM192

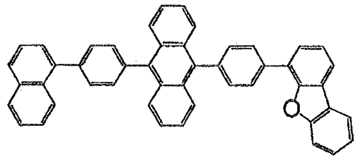

EM201

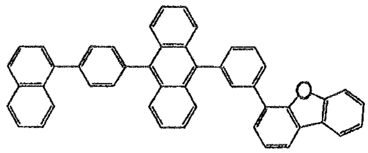

EM202

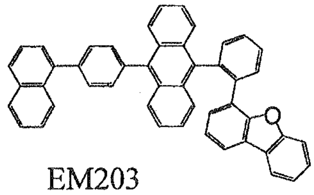

EM203

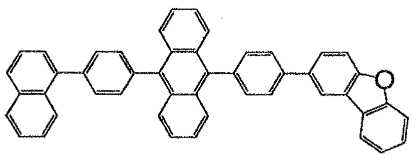

EM204

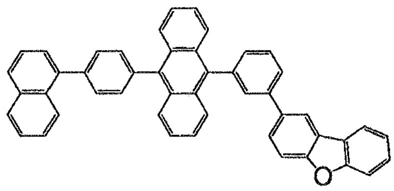

EM205

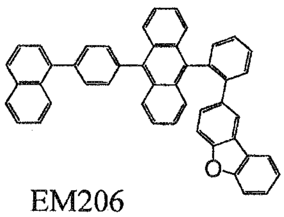

EM206

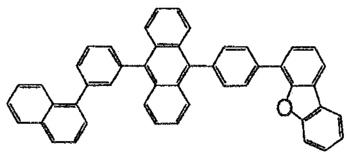

EM207

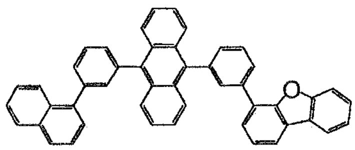

EM208

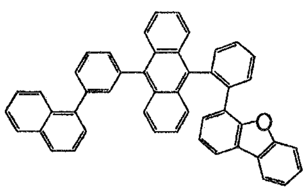

EM209

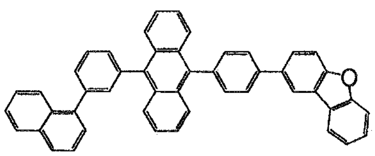

EM210

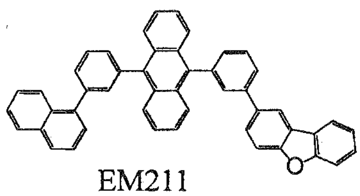

EM211

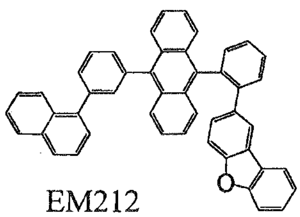
EM212

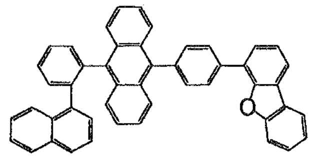
EM213

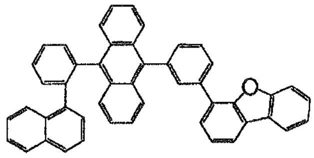
EM214

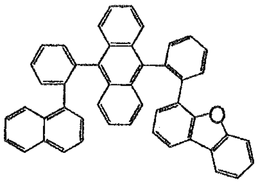
EM215

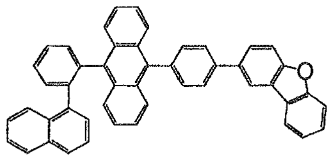
EM216

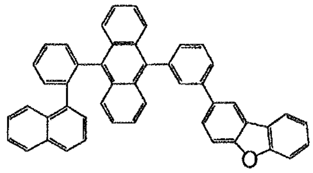
EM217

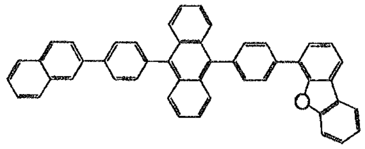
EM218

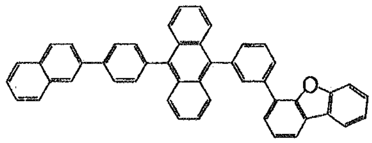
EM219

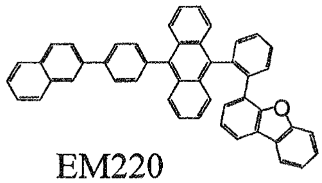
EM220

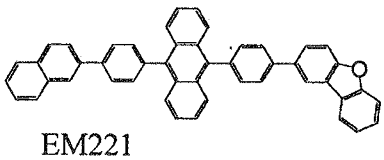
EM221

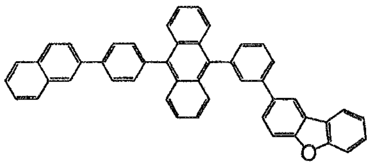
EM222

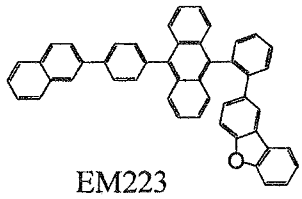
EM223

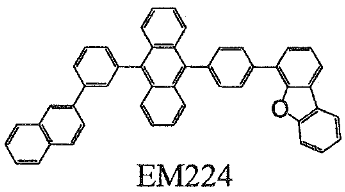
EM224

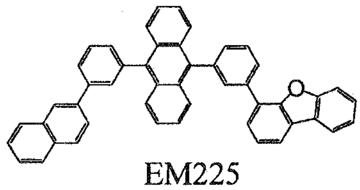
EM225

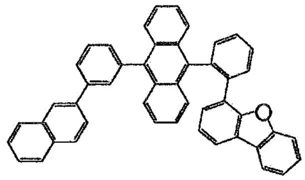
EM226

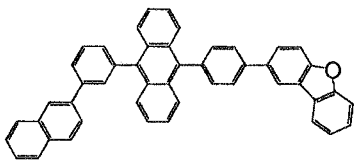
EM227

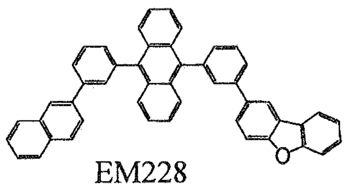
EM228

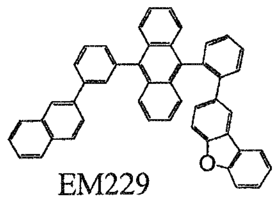
EM229

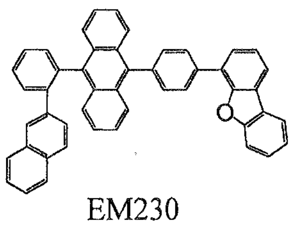
EM230

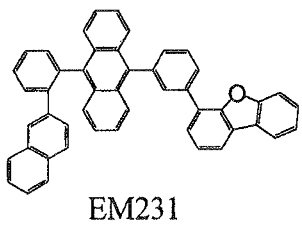
EM231

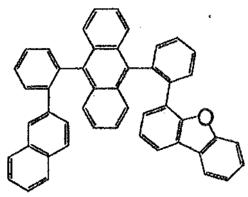
EM232

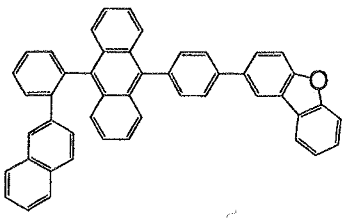

EM233

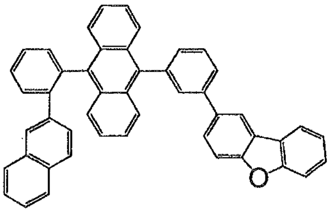

EM234

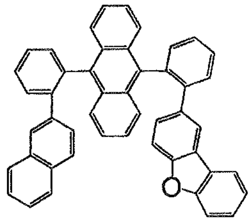

EM235

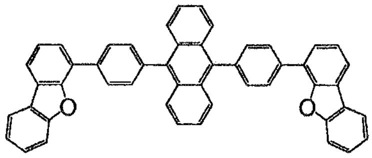

EM236

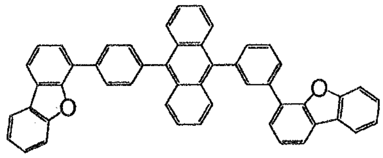

EM237

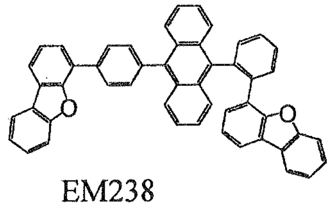

EM238

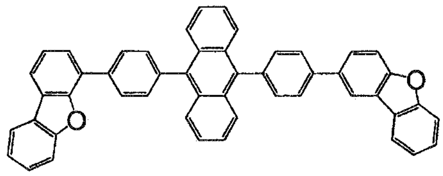

EM239

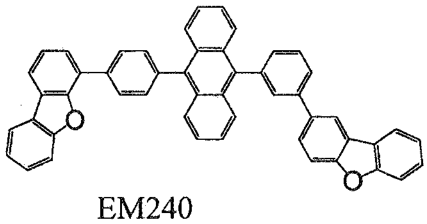

EM240

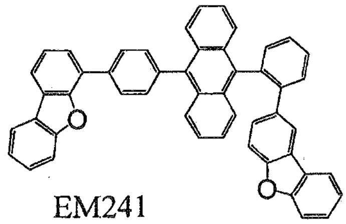

EM241

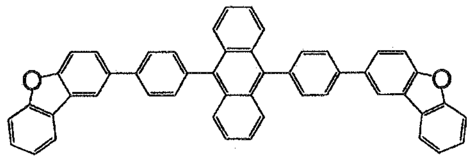

EM242

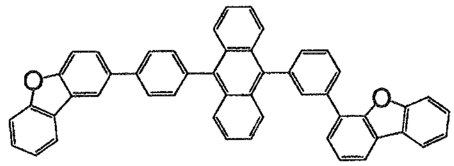

EM243

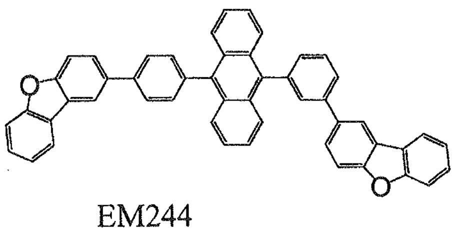

EM244

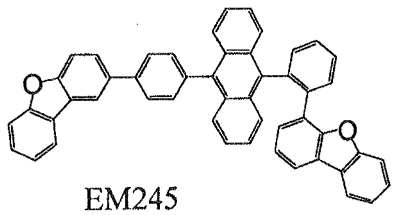

EM245

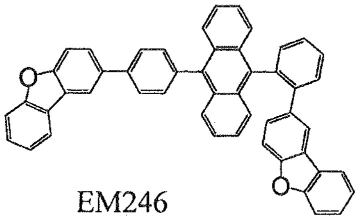

EM246

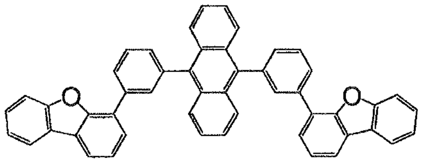

EM247

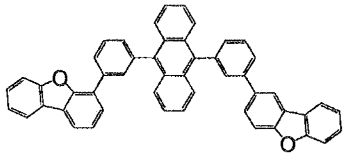

EM248

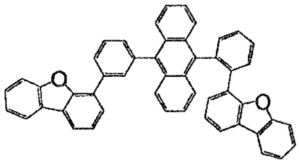

EM249

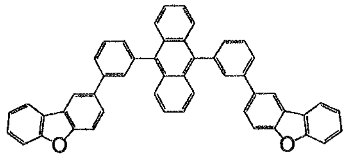

EM250

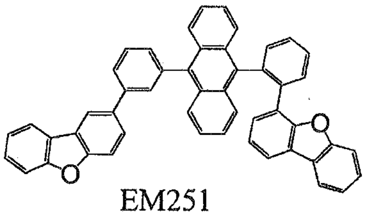

EM251

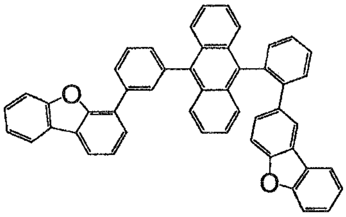

EM252

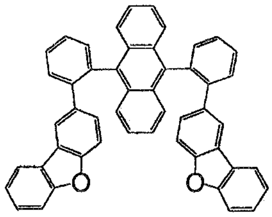

EM253

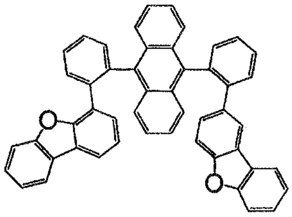

EM254

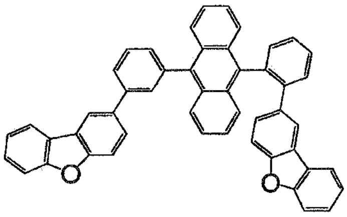

EM255

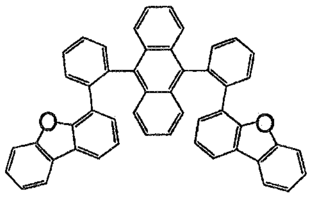

EM256

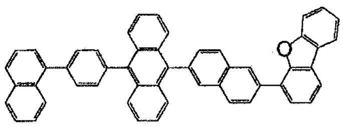

EM257

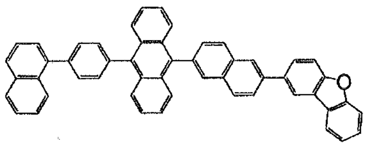

EM258

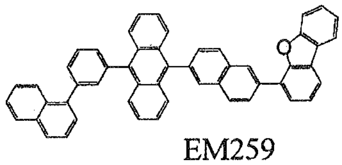

EM259

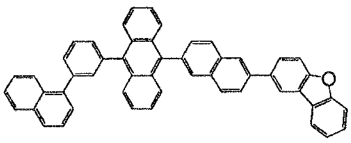

EM260

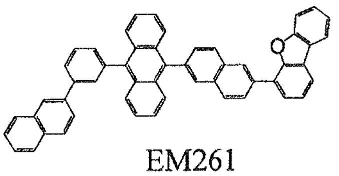

EM261

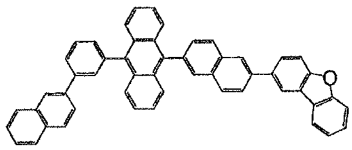

EM262

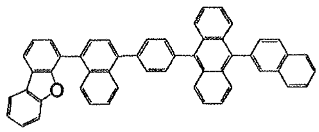
EM263

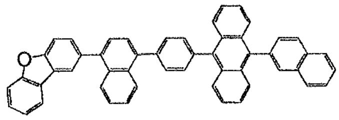
EM264

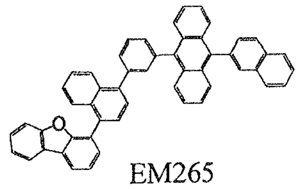
EM265

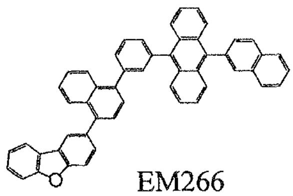
EM266

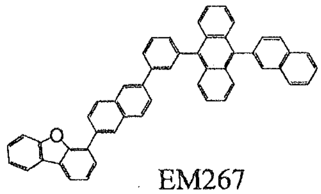
EM267

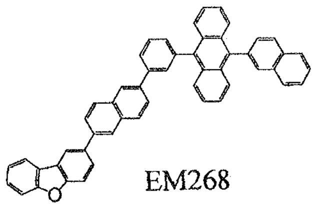
EM268

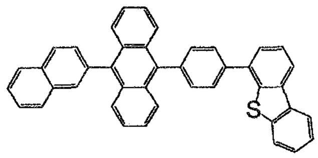
EM269

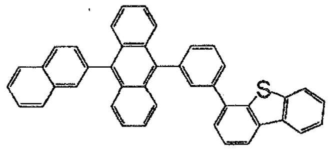
EM270

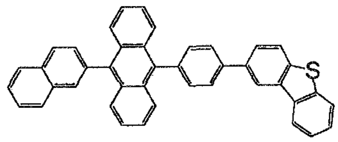
EM271

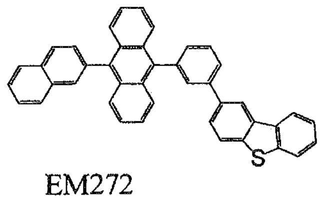
EM272

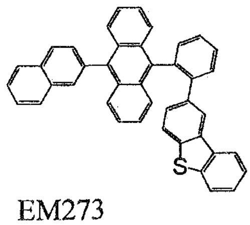
EM273

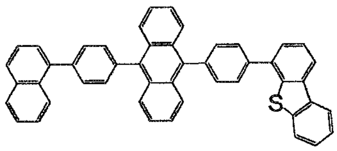
EM274

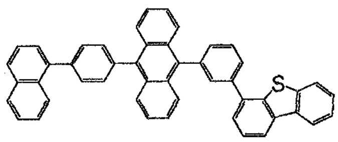
EM275

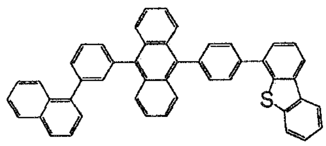
EM276

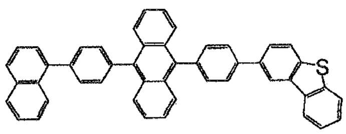
EM277

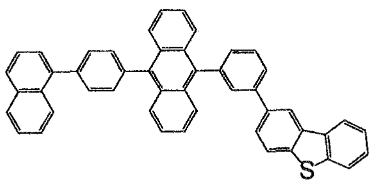
EM278

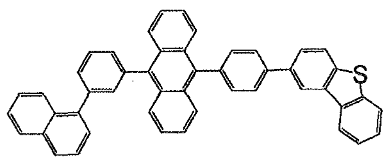
EM279

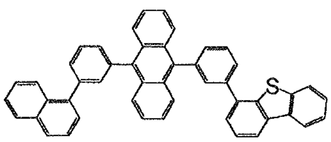
EM280

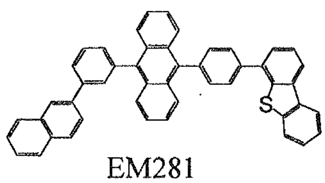
EM281

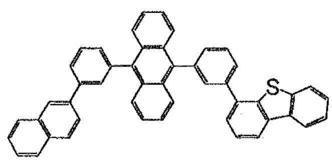
EM282

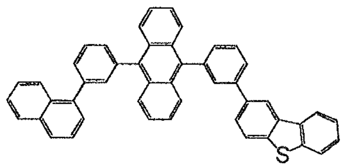

EM283

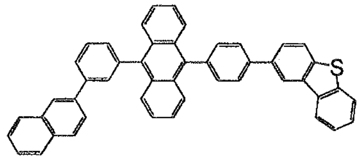

EM284

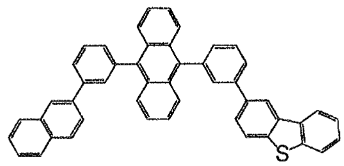

EM285

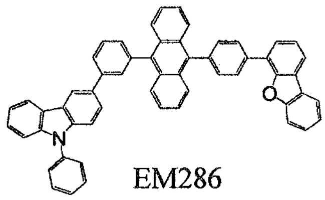

EM286

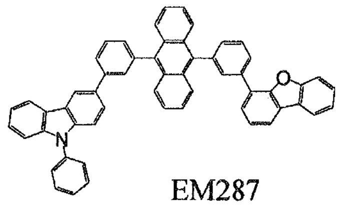

EM287

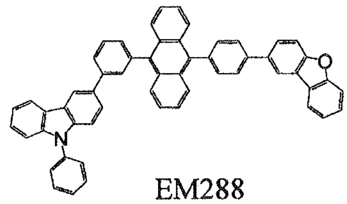

EM288

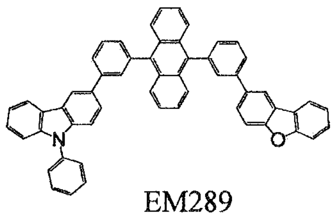

EM289

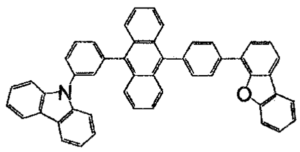

EM290

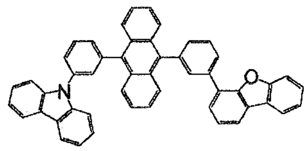

EM291

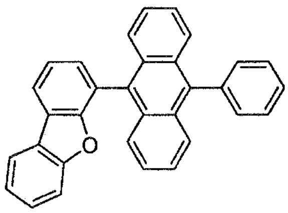

EM292

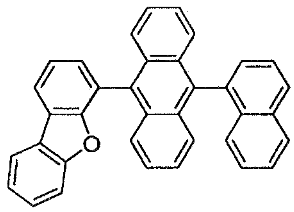

EM293

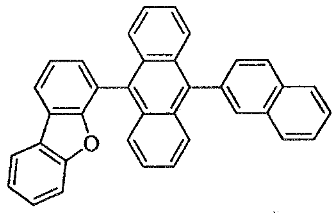

EM294

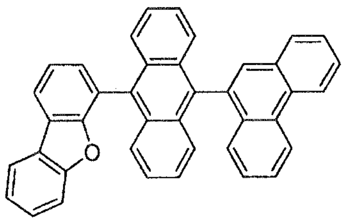

EM295

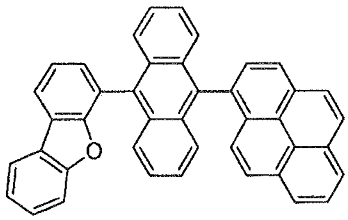

EM296

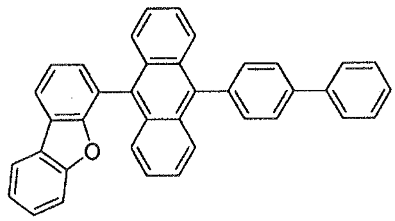

EM297

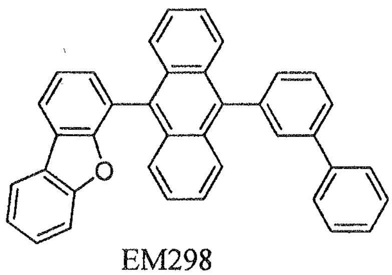

EM298

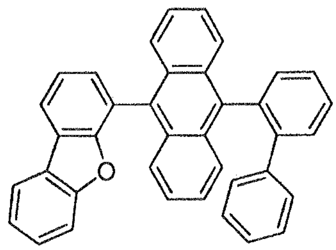

EM299

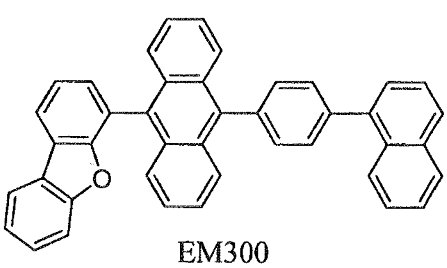

EM300

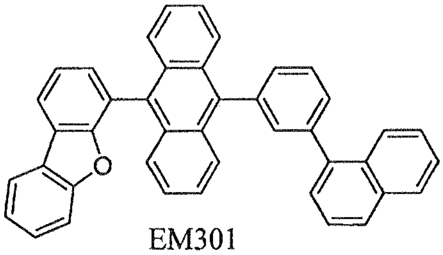

EM301

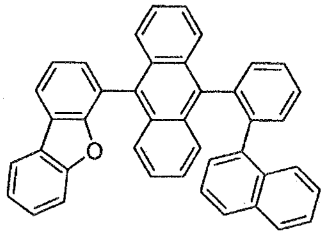

EM302

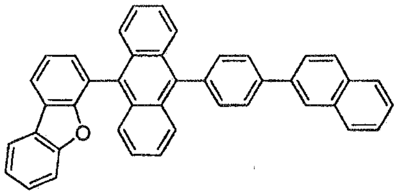

EM303

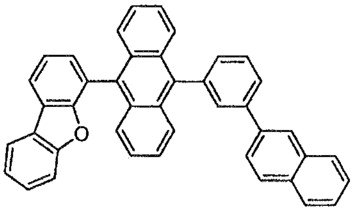

EM304

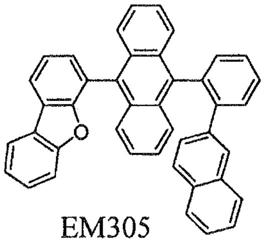

EM305

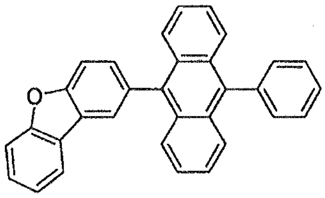

EM306

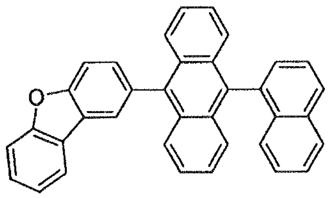

EM307

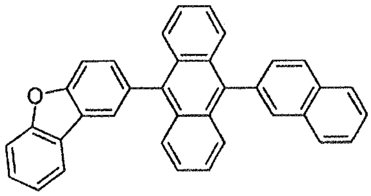

EM308

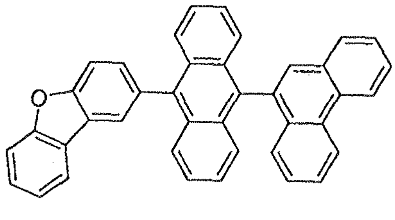

EM309

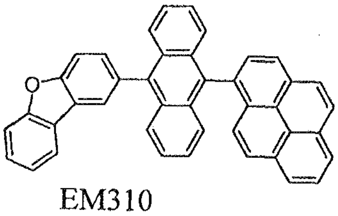

EM310

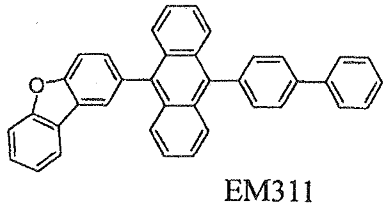

EM311

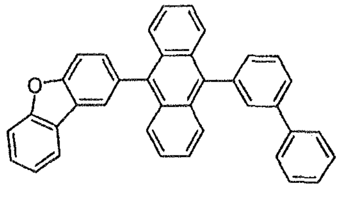

EM312

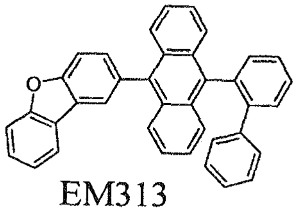
EM313

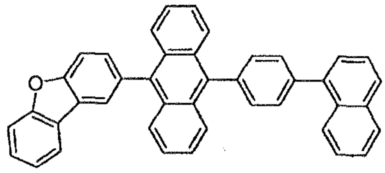
EM314

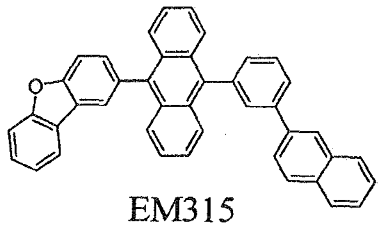
EM315

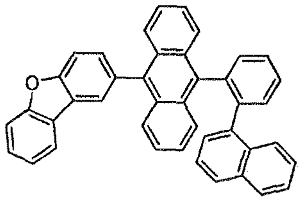
EM316

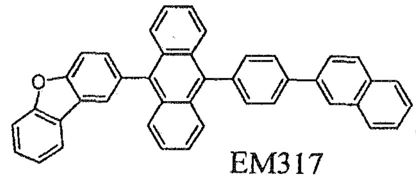
EM317

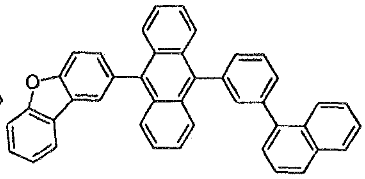
EM318

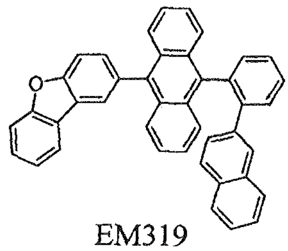
EM319

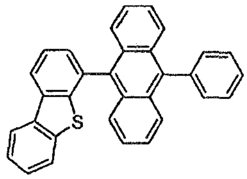
EM320

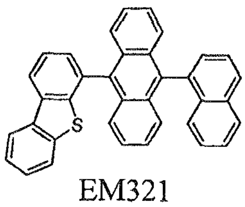
EM321

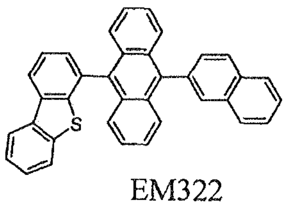
EM322

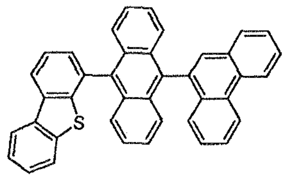
EM323

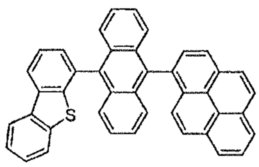
EM324

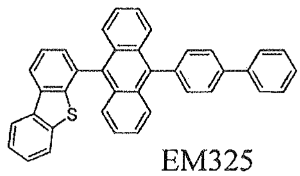
EM325

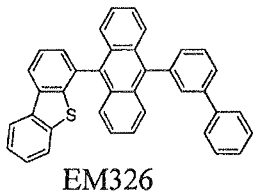
EM326

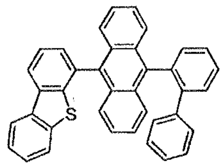
EM327

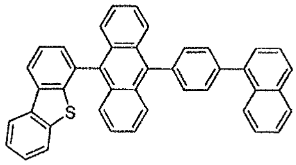
EM328

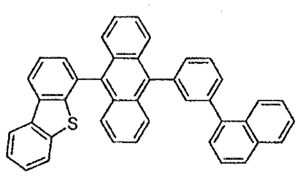
EM329

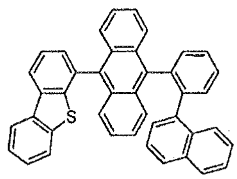
EM330

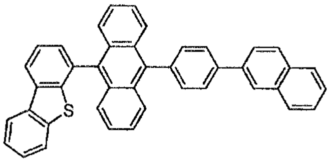
EM331

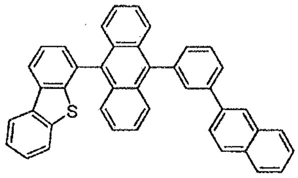
EM332

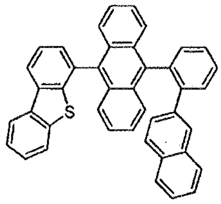
EM333

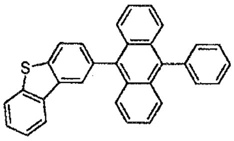
EM334

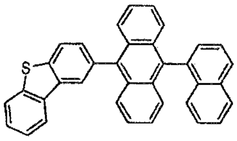
EM335

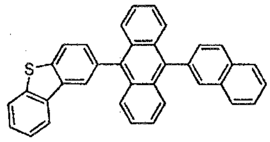
EM336

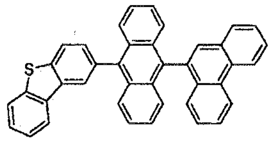
EM337

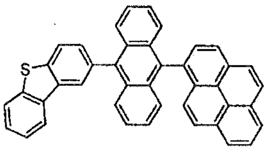
EM338

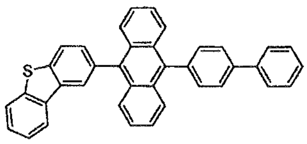
EM339

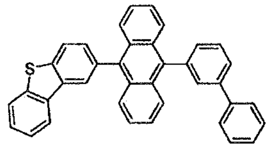
EM340

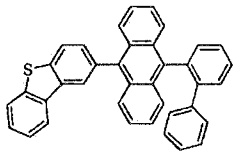
EM341

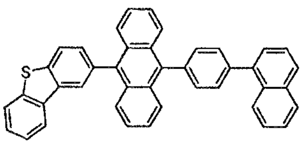
EM342

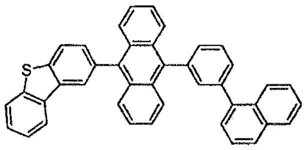
EM343

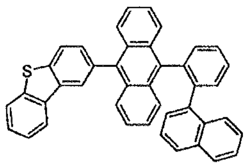
EM344

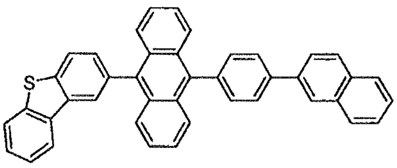
EM345

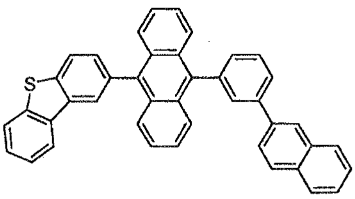
EM346

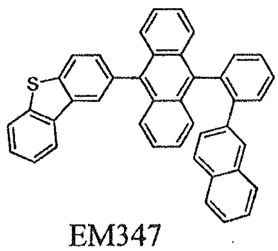
EM347

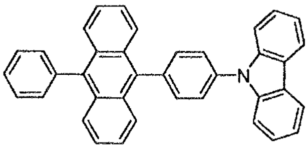
EM348

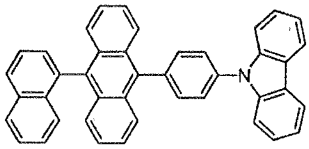
EM349

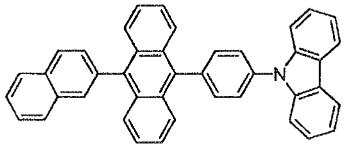
EM350

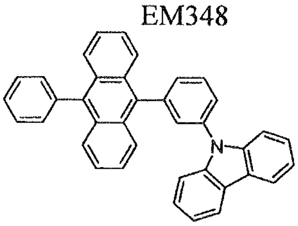
EM351

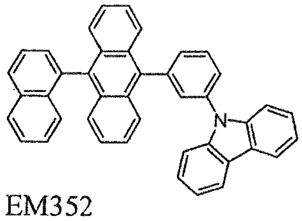
EM352

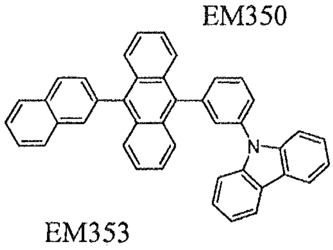
EM353

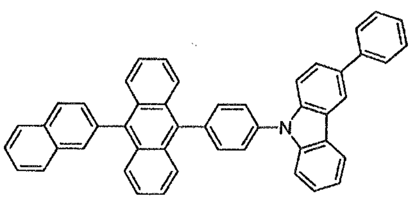
EM354

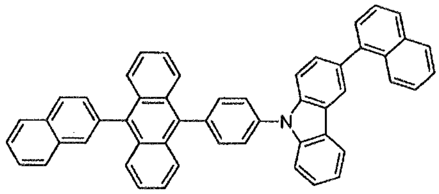
EM355

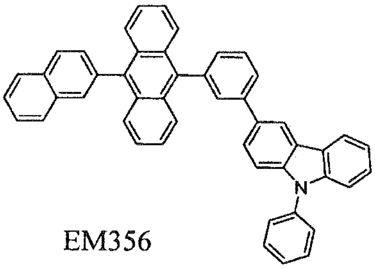
EM356

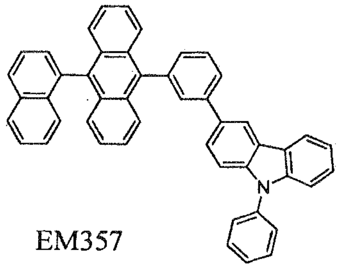
EM357

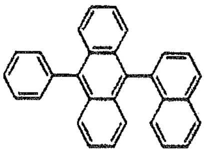
EM358

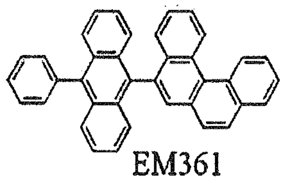
EM361

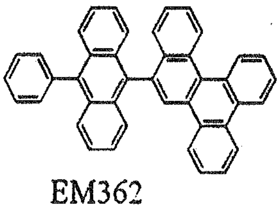
EM362

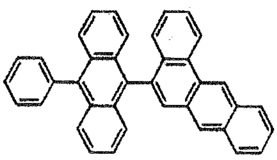
EM363

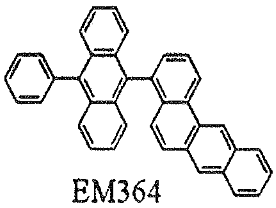
EM364

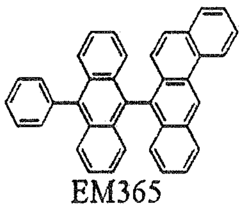
EM365

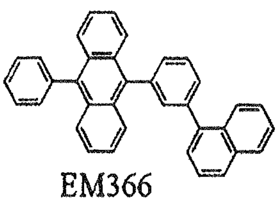
EM366

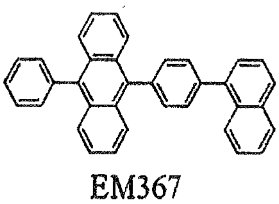
EM367

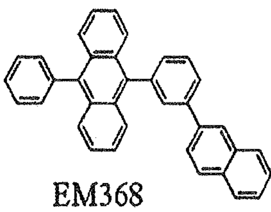
EM368

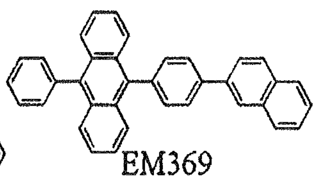
EM369

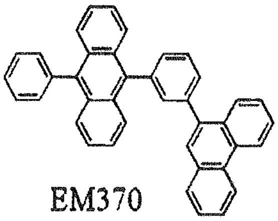
EM370

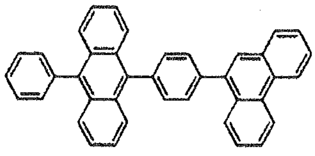
EM371

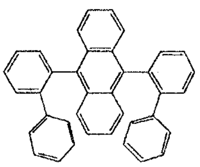
EM373

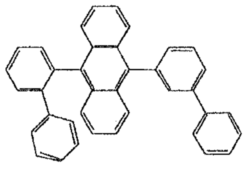
EM374

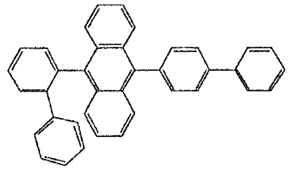
EM375

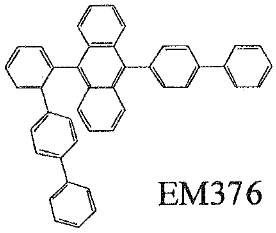
EM376

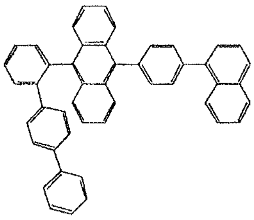
EM377

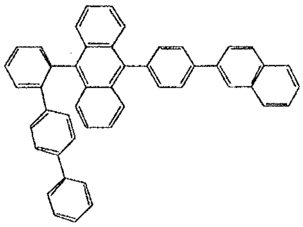
EM378

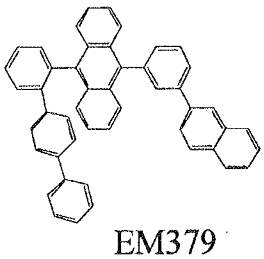
EM379

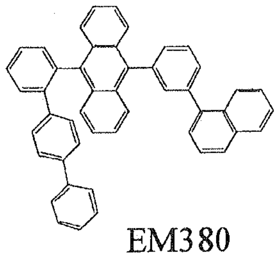
EM380

The organic luminesent medium of the invention preferably contains the above-mentioned aromatic amine derivative as a doping material (dopant). In this case, the amount of the aromatic amine derivative is preferably 0.1 to 20 mass%, more preferably 1 to 10 mass%. In this case, the anthracene derivative is a host material and generally the total sum of a host material and a dopant material is 100 mass%.

The organic EL device of the invention comprises one or more organic thin film layers comprising an emitting layer between an anode and a cathode. At least one layer of the organic thin film layers contains the organic thin film containing the organic luminescent medium of the invention.

The aromatic amine derivative and the anthracene derivative may be used in a hole-injecting layer, a hole-transporting layer, an electron-injecting layer, and an electron-transporting layer in addition to an emitting layer.

In the invention, as the organic EL device in which the organic thin film layer is composed of plural layers, one in which layers are sequentially stacked (anode/hole-injecting layer/emitting layer/cathode), (anode/emitting layer/electron-injecting layer/cathode), (anode/hole-injecting layer/emitting layer/electron-injecting layer/cathode), (anode/hole-injecting layer/hole-transporting layer/emitting layer/electron-injecting layer/cathode) or the like can be given.

By allowing the organic thin film layer to be composed of plural layers, the organic EL device can be prevented from lowering of luminance or lifetime due to quenching. If necessary, an emitting material, a doping material, a hole-injecting material or an electron-injecting material can be used in combination. Further, due to the use of a doping material, luminance or luminous efficiency may be improved. The hole-injecting layer, the emitting layer and the electron-injecting layer may respectively be formed of two or more layers. In such case, in the hole-injecting layer, a layer which injects holes from an electrode is referred to as a hole-injecting layer, and a layer which receives holes from the hole-injecting layer and transports the holes to the emitting layer is referred to as a hole-transporting layer. Similarly, in the electron-injecting layer, a layer which injects electrons from an electrode is referred to as an electron-injecting layer and a layer which receives electrons from an electron-injecting layer and transports the electrons to the emitting layer is referred to as an electron-transporting layer. Each of these layers is selected and used according to each of the factors of a material, i.e. the energy level, heat resistance, adhesiveness to the organic layer or the metal electrode or the like.

Examples of the material other than the above anthracene derivative which can be used in the emitting layer together with the aromatic amine derivative include, though not limited thereto, fused polycyclic aromatic compounds such as naphthalene, phenanthrene, rubrene, tetracene, pyrene, perylene, chrysene, decacyclene, coronene, tetraphenylcyclopentadiene, pentaphenylcyclopentadiene, fluorene, spirofluorene and derivatives thereof, organic metal complexes such as tris(8-quinolinolate)aluminum, triarylamine derivatives, styrylamine derivatives, stilbene derivatives, coumarin derivatives, pyrane derivatives, oxazone derivatives, benzothiazole derivatives, benzoxazole derivatives, benzimidazole derivatives, pyrazine derivatives, cinnamate derivatives, diketo-pyrrolo-pyrrole derivatives, acrylidone derivatives and quinacrylidone derivatives.

As the hole-injecting material, a compound which can transport holes, exhibits hole-injecting effects from the anode and excellent hole-injection effect for the emitting layer or the emitting material, and has an excellent capability of forming a thin film is preferable. Specific examples thereof include, though not limited thereto, phthalocyanine derivatives, naphthalocyanine derivatives, porphyline derivatives, benzidine-type triphenylamine, diamine-type triphenylamine, hexacyanohexaazatriphenylene, derivatives thereof, and polymer materials such as polyvinylcarbazole, polysilane and conductive polymers.

Of the hole-injecting materials usable in the organic EL device of the invention, further effective hole-injecting materials are phthalocyanine derivatives.

Examples of the phthalocyanine (Pc) derivative include, though not limited thereto, phthalocyanine derivatives such as $H_2Pc$, CuPc, CoPc, NiPc, ZnPc, PdPc, FePc, MnPc, ClAlPc, ClGaPc, ClInPc, ClSnPc, $Cl_2SiPc$, (HO)AlPc, (HO)GaPc, VOPc, TiOPc, MoOPc and GaPc-O-GaPc, and naphthalocyanine derivatives.

In addition, it is also possible to sensitize carriers by adding to the hole-injecting material an electron-accepting substance such as a TCNQ derivative.

Preferable hole-transporting materials usable in the organic EL device of the invention are aromatic tertiary amine derivatives.

Examples of the aromatic tertiary amine derivative include, though not limited thereto, N,N'-diphenyl-N,N'-dinaphthyl-1,1'-biphenyl-4,4'-diamine, N,N,N',N'-tetrabiphenyl-1,1'-biphenyl-4,4'-diamineor an oligomer or a polymer having these aromatic tertiary amine skeletons.

As the electron-injecting material, a compound which can transport electrons, exhibits electron-injecting effects from the cathode and excellent electron-injection effect for the emitting layer or the emitting material, and has an excellent capability of forming a thin film is preferable.

In the organic EL device of the invention, further effective electron-injecting materials are a metal complex compound and a nitrogen-containing heterocyclic derivative.

Examples of the metal complex compound include, though not limited thereto, 8-hydroxyquinolinate lithium, bis(8-hydroxyquinolinate)zinc, tris(8-hydroxyquinolinate)aluminum, tris(8-hydroxyquinolinate)gallium, bis(10-hydroxybenzo[h]quinolinate)beryllium and bis(10-hydroxybenzo[h]quinolinate)zinc.

As examples of the nitrogen-containing heterocyclic derivative, oxazole, thiazole, oxadiazole, thiadiazole, triazole, pyridine, pyrimidine, triazine, phenanthroline, benzoimidazole, imidazopyridine or the like are preferable, for example. Of these, a benzimidazole derivative, a phenanthroline derivative and an imidazopyridine derivative are preferable.

As a preferred embodiment, a dopant is further contained in these electron-injecting materials, and in order to facilitate receiving electrons from the cathode, it is further preferable to dope the vicinity of the cathode interface of the second organic layer with a dopant, the representative example of which is an alkali metal.

As the dopant, a donating metal, a donating metal compound and a donating metal complex can be given. These reducing dopants may be used singly or in combination of two or more.

In the organic EL device of the invention, the emitting layer may contain, in addition to at least one of the above-mentioned aromatic amine derivatives represented by the formula (1), at least one of an emitting material, doping material, hole-injecting material, hole-transporting material and electron-injecting material in the same layer. Moreover, for improving stability of the organic EL device obtained by the invention to temperature, humidity, atmosphere, etc. it is also possible to prepare a protective layer on the surface of the device, and it is also possible to protect the entire device by applying silicone oil, resin, etc.

As the conductive material used in the anode of the organic EL device of the invention, a conductive material having a work function of more than 4 eV is suitable. Carbon, aluminum, vanadium, iron, cobalt, nickel, tungsten, silver, gold, platinum, palladium or the like, alloys thereof, oxidized metals which are used in an ITO substrate and a NESA substrate such as tin oxide and indium oxide and organic conductive resins such as polythiophene and polypyrrole are used. As the conductive material used in the cathode, a conductive material having a work function of smaller than 4 eV is suitable. Magnesium, calcium, tin, lead, titanium, yttrium, lithium, ruthenium, manganese, aluminum, and lithium fluoride or the like, and alloys thereof are used, but not limited thereto. Representative examples of the alloys include, though not limited thereto, magnesium/silver alloys, magnesium/indium alloys and lithium/aluminum alloys. The amount ratio of the alloy is controlled by the temperature of the deposition source, atmosphere, vacuum degree or the like, and an appropriate ratio is selected. If necessary, the anode and the cathode each may be composed of two or more layers.

In the organic EL device of the invention, in order to allow it to emit light efficiently, it is preferred that at least one of the surfaces be fully transparent in the emission wavelength region of the device. In addition, it is preferred that the substrate also be transparent. The transparent electrode is set such that predetermined transparency can be ensured by a method such as deposition or sputtering by using the above-mentioned conductive materials. It is preferred that the electrode on the emitting surface have a light transmittance of 10% or more. Although no specific restrictions are imposed on the substrate as long as it has mechanical and thermal strength and transparency, a glass substrate and a

transparent resin film can be given.

Each layer of the organic EL device of the invention can be formed by a dry film-forming method such as vacuum vapor deposition, sputtering, plasma, ion plating or the like or a wet film-forming method such as spin coating, dipping, flow coating or the like. Although the film thickness is not particularly limited, it is required to adjust the film thickness to an appropriate value. If the film thickness is too large, a large voltage is required to be applied in order to obtain a certain optical output, which results in a poor efficiency. If the film thickness is too small, pinholes or the like are generated, and a sufficient luminance cannot be obtained even if an electrical field is applied. The suitable film thickness is normally 5 nm to 10 μm, with a range of 10 nm to 0.2 μm being further preferable.

In the case of the wet film-forming method, a thin film is formed by dissolving or dispersing materials forming each layer in an appropriate solvent such as ethanol, chloroform, tetrahydrofuran and dioxane. Any of the above-mentioned solvents can be used.

In each organic thin film layer, an appropriate resin or additive may be used in order to improve film-forming properties, to prevent generation of pinholes in the film, or for other purposes.

The organic EL device of the invention can be suitably used as a planar emitting body such as a flat panel display of a wall-hanging television, backlight of a copier, a printer or a liquid crystal display, light sources for instruments, a display panel, a navigation light, or the like. The compound of the invention can be used not only in an organic EL device but also in the field of an electrophotographic photoreceptor, a photoelectric converting element, a solar cell and an image sensor.

EXAMPLES

Example 1

A glass substrate of 25 mm by 75 mm by 1.1 mm thick with an ITO transparent electrode (anode) (GEOMATEC CO., LTD.) was subjected to ultrasonic cleaning in isopropyl alcohol for 5 minutes, and cleaning with ozone for 30 minutes. The resultant substrate with transparent electrode lines was mounted on a substrate holder in a vacuum deposition device. First, compound A-1 was deposited on the surface on which the transparent electrode lines were formed to form a 50 nm-thick film so as to cover the transparent electrode. Subsequently, compound A-2 was deposited on the A-1 film to form a 45 nm-thick film.

Compound EM13 and compound DM-1 were deposited on the A-2 film into a thickness of 20 nm such that the film thickness ratio of EM13 and DM-1 became 20:1 to form a blue emitting layer.

On this film, the following ET-1 was deposited into a thickness of 30 nm as an electron-transporting layer. Then LiF was deposited into a thickness of 1 nm. Metallic Al was deposited on the LiF film into a thickness of 150 nm to form a metallic cathode, whereby an organic EL device was fabricated.

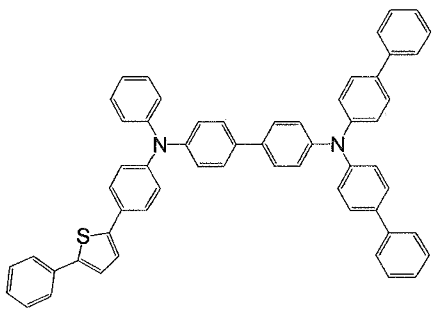

A-1

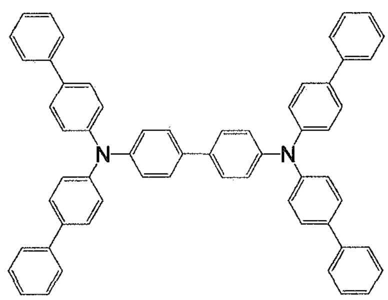

A-2

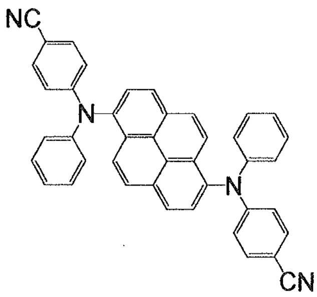

DM-1

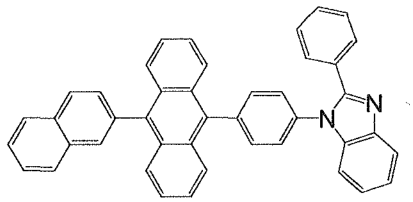

ET-1

Examples 2-54 and Comparative Example 1-9

An organic EL device was produced in the same manner as in Example 1, except that the host material and doping material shown in Tables 1 and 2 were used.
The doping materials used in Examples and Comparative Examples are shown below.

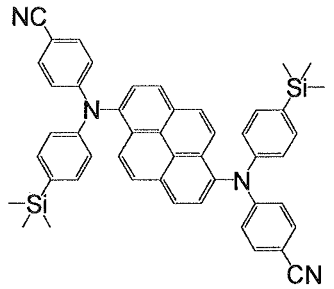

DM-2

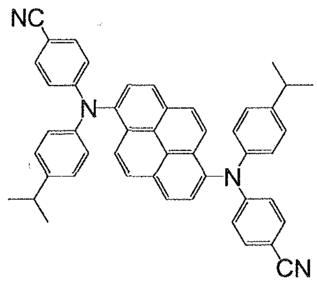

DM-3

Host materials which were used in Comparative Examples are shown below.

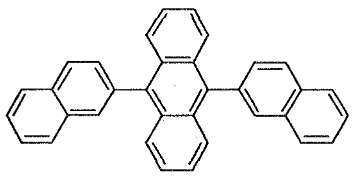

Compound A

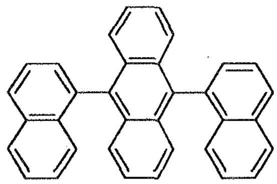

Compound B

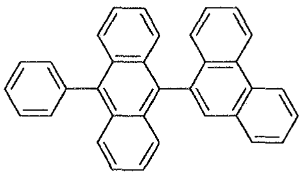

Compound C

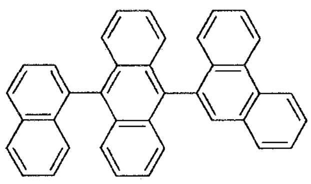

Compound D

Current having a current density of 10 mA/cm$^2$was applied to the organic EL devices obtained were applied current having EL spectra thereof were measured with a spectroradiometer (CS1000, produced by MINOLTA), and external quantum efficiency was calculated by the following formula (1).
The lifetime of the organic EL device was evaluated by measuring the half life at 500 cd/m$^2$ of initial luminance. The results are shown in Tables 1 and 2.

$$E.Q.E. = \frac{N_P}{N_E} \times 100$$

$$= \frac{\dfrac{(\pi/10^9)\int \phi(\lambda)\cdot d\lambda}{hc}}{\dfrac{J/10}{e}} \times 100$$

$$= \frac{\dfrac{(\pi/10^9)\,\Sigma(\phi(\lambda)\cdot(\lambda))}{hc}}{\dfrac{J/10}{e}} \times 100\ (\%)$$

$N_P$: Number of photons
$N_E$: Number of electrons
$\pi$: Circular constant = 3.1416
$\lambda$: Wavelength (nm)
$\varphi$: Luminescence intensity ($W/sr\cdot m^2\cdot nm$)
h: Planck constant = $6.63 \times 10^{-34}$ (J·s)
c: Light velocity = $3 \times 10^8$ (m/s)
J: Current density ($mA/cm^2$)
e: Charge = $1.6 \times 10^{-19}$ (C)

Table 1

| | Host | Dopant | CIEx | CIEy | EQE(%) | Lifetime(h) |
|---|---|---|---|---|---|---|
| Example 1 | EM13 | DM-1 | 0.137 | 0.094 | 7.0 | 3000 |
| Example 2 | EM28 | DM-1 | 0.137 | 0.094 | 7.0 | 3100 |
| Example 3 | EM29 | DM-1 | 0.137 | 0.093 | 6.5 | 2500 |
| Example 4 | EM31 | DM-1 | 0.137 | 0.094 | 7.0 | 3300 |
| Example 5 | EM32 | DM-1 | 0.137 | 0.096 | 6.9 | 3200 |
| Example 6 | EM69 | DM-1 | 0.137 | 0.096 | 6.8 | 2900 |
| Example 7 | EM70 | DM-1 | 0.137 | 0.094 | 6.8 | 2800 |
| Example 8 | EM73 | DM-1 | 0.137 | 0.096 | 6.9 | 3000 |
| Example 9 | EM78 | DM-1 | 0.137 | 0.096 | 6.8 | 2500 |
| Example 10 | EM82 | DM-1 | 0.137 | 0.096 | 6.7 | 2500 |
| Example 11 | EM125 | DM-1 | 0.137 | 0.096 | 6.9 | 2900 |
| Example 12 | EM205 | DM-1 | 0.137 | 0.096 | 6.7 | 2400 |
| Example 13 | EM364 | DM-1 | 0.137 | 0.101 | 6.4 | 2000 |
| Example 14 | EM367 | DM-1 | 0.137 | 0.096 | 6.7 | 2200 |
| Example 15 | EM361 | DM-1 | 0.137 | 0.099 | 6.8 | 3100 |
| Example 16 | EM15 | DM-1 | 0.137 | 0.095 | 6.8 | 2900 |
| Example 17 | EM37 | DM-1 | 0.137 | 0.093 | 6.8 | 2800 |
| Example 18 | EM81 | DM-1 | 0.137 | 0.094 | 7.0 | 3200 |

(continued)

| | Host | Dopant | CIEx | CIEy | EQE(%) | Lifetime(h) |
|---|---|---|---|---|---|---|
| Example 19 | EM13 | DM-2 | 0.137 | 0.096 | 7.4 | 3100 |
| Example 20 | EM28 | DM-2 | 0.137 | 0.096 | 7.4 | 3200 |
| Example 21 | EM29 | DM-2 | 0.137 | 0.095 | 6.9 | 2600 |
| Example 22 | EM31 | DM-2 | 0.137 | 0.096 | 7.4 | 3400 |
| Example 23 | EM32 | DM-2 | 0.137 | 0.098 | 7.3 | 3300 |
| Example 24 | EM69 | DM-2 | 0.137 | 0.098 | 7.2 | 3000 |
| Example 25 | EM70 | DM-2 | 0.137 | 0.096 | 7.2 | 2900 |
| Example 26 | EM73 | DM-2 | 0.137 | 0.098 | 7.3 | 3100 |
| Example 27 | EM78 | DM-2 | 0.137 | 0.098 | 7.2 | 2600 |
| Example 28 | EM82 | DM-2 | 0.137 | 0.098 | 7.1 | 2600 |
| Example 29 | EM125 | DM-2 | 0.137 | 0.098 | 7.3 | 3000 |
| Example 30 | EM205 | DM-2 | 0.137 | 0.098 | 7.1 | 2500 |
| Example 31 | EM364 | DM-2 | 0.137 | 0.103 | 6.8 | 2100 |
| Example 32 | EM367 | DM-2 | 0.137 | 0.098 | 7.1 | 2300 |
| Example 33 | EM361 | DM-2 | 0.137 | 0.101 | 7.2 | 2800 |
| Example 34 | EM15 | DM-2 | 0.137 | 0.098 | 6.9 | 3000 |
| Example 35 | EM37 | DM-2 | 0.137 | 0.097 | 6.8 | 2900 |
| Example 36 | EM81 | DM-2 | 0.137 | 0.098 | 6.9 | 3300 |

Table 2

| | Host | Dopant | CIEx | CIEy | EQE (%) | Lifetime (h) |
|---|---|---|---|---|---|---|
| Example 37 | EM13 | DM-3 | 0.129 | 0.146 | 7.0 | 3500 |
| Example 38 | EM28 | DM-3 | 0.129 | 0.146 | 7.0 | 3600 |
| Example 39 | EM29 | DM-3 | 0.129 | 0.145 | 6.5 | 3000 |
| Example 40 | EM31 | DM-3 | 0.129 | 0.146 | 7.0 | 3800 |
| Example 41 | EM32 | DM-3 | 0.129 | 0.148 | 6.9 | 3700 |
| Example 42 | EM69 | DM-3 | 0.129 | 0.148 | 6.8 | 3400 |
| Example 43 | EM70 | DM-3 | 0.129 | 0.146 | 6.8 | 3300 |
| Example 44 | EM73 | DM-3 | 0.129 | 0.148 | 6.9 | 3500 |
| Example 45 | EM78 | DM-3 | 0.129 | 0.148 | 6.8 | 3000 |
| Example 46 | EM82 | DM-3 | 0.129 | 0.148 | 6.7 | 3000 |
| Example 47 | EM125 | DM-3 | 0.129 | 0.148 | 6.9 | 3400 |
| Example 48 | EM205 | DM-3 | 0.129 | 0.148 | 6.7 | 2900 |
| Example 49 | EM364 | DM-3 | 0.129 | 0.153 | 6.4 | 2500 |
| Example 50 | EM367 | DM-3 | 0.129 | 0.148 | 6.7 | 2700 |
| Example 51 | EM361 | DM-3 | 0.129 | 0.148 | 6.8 | 3000 |
| Example 52 | EM15 | DM-3 | 0.129 | 0.15 | 6.8 | 3500 |

(continued)

| | Host | Dopant | CIEx | CIEy | EQE (%) | Lifetime (h) |
|---|---|---|---|---|---|---|
| Example 53 | EM37 | DM-3 | 0.129 | 0.148 | 6.8 | 3300 |
| Example 54 | EM81 | DM-3 | 0.129 | 0.148 | 6.9 | 3800 |
| Com. Example 1 | Compound A | DM-1 | 0.137 | 0.098 | 6.1 | 1200 |
| Com. Example 2 | Compound B | DM-1 | 0.137 | 0.096 | 5.9 | 1000 |
| Com. Example 3 | Compound D | DM-1 | 0.137 | 0.096 | 6.0 | 1100 |
| Com. Example 4 | Compound A | DM-2 | 0.137 | 0.100 | 6.3 | 1400 |
| Com. Example 5 | Compound B | DM-2 | 0.137 | 0.097 | 6.2 | 1200 |
| Com. Example 6 | Compound D | DM-2 | 0.137 | 0.098 | 6.2 | 1200 |
| Com. Example 7 | Compound A | DM-3 | 0.129 | 0.146 | 6.1 | 1000 |
| Com. Example 8 | Compound B | DM-3 | 0.129 | 0.150 | 6.1 | 1200 |
| Com. Example 9 | Compound C | DM-3 | 0.129 | 0.148 | 6.0 | 1200 |

From Tables 1 and 2, it can be understood that the combination of the host material and the dopant material of the invention tends to enable an organic EL device to emit blue light which has remarkable color purity, and enables an organic EL device to have a significantly long lifetime as compared with conventional organic EL devices. As a result, a display device having a long life and high color reproducibility can be realized.

INDUSTRIAL APPLICABILITY

The organic EL device of the invention can be suitably used as a planar emitting body such as a flat panel display of a wall television, backlight of a copier, a printer, or a liquid crystal display, light sources for instruments, a display panel, a navigation light, and the like.

Although only some exemplary embodiments and/or examples of this invention have been described in detail above, those skilled in the art will readily appreciate that many modifications are possible in the exemplary embodiments and/or examples without materially departing from the novel teachings and advantages of this invention. Accordingly, all such modifications are intended to be included within the scope of this invention.

The documents described in the specification are incorporated herein by reference in its entirety.

**Claims**

1. An organic luminescent medium comprising an aromatic amine derivative represented by the following formula (1) and an anthracene derivative represented by the following formula (I):

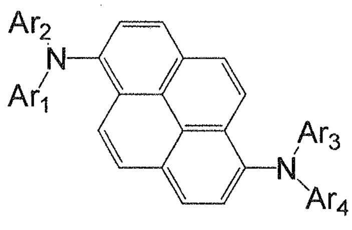

(1)

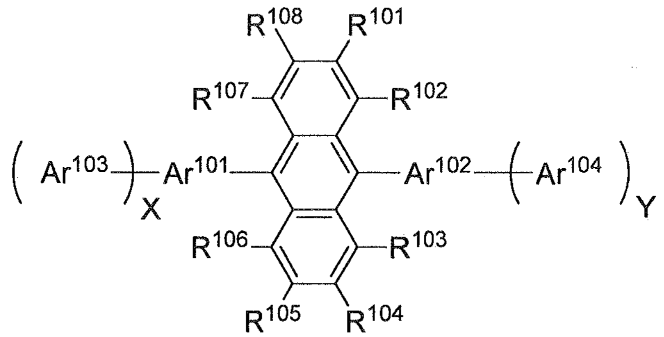

(I)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,
in formula (I), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms, or a substituted or unsubstituted heterocyclic group having 5 to 30 ring atoms,
$Ar^{101}$ to $Ar^{104}$ are a substituted or unsubstituted aryl group having 6 to 30 ring carbon atoms or a substituted or unsubstituted heterocyclic group having 5 to 30 ring atoms,
X is an integer of 0 to 3, and
Y is an integer of 1 to 3.

**2.** An organic luminescent medium comprising an aromatic amine derivative represented by the following formula (1) and an anthracene derivative represented by the following formula (II):

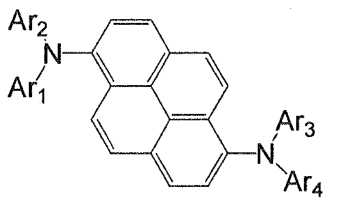

(1)

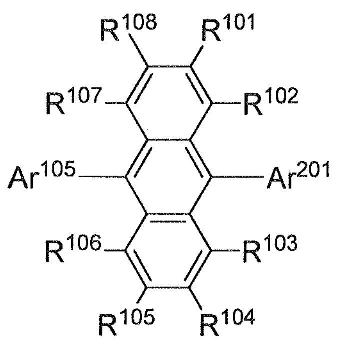

(II)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,
in formula (II), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl

group having 6 to 30 ring carbon atoms, or a substituted or unsubstituted heterocyclic group having 5 to 30 ring atoms, $Ar^{105}$ is a substituted or unsubstituted aryl group having 6 to 30 ring carbon atoms or a substituted or unsubstituted heterocyclic group having 5 to 30 ring atoms, and
$Ar^{201}$ is a substituted or unsubstituted fused aromatic ring group having 16 to 30 ring carbon atoms, or a substituted or unsubstituted fused heterocyclic group having 10 to 30 ring atoms.

**3.** An organic luminescent medium comprising an aromatic amine derivative represented by the following formula (1) and an anthracene derivative represented by the following formula (III):

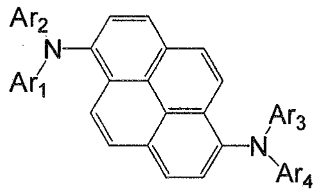
(1)

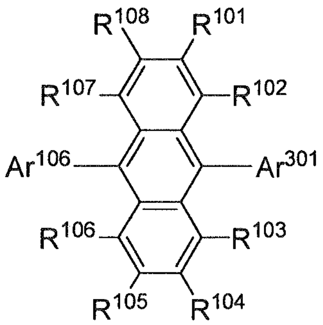
(III)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,
in formula (III), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms, or a substituted or unsubstituted heterocyclic group having 5 to 30 ring atoms, $Ar^{106}$ is a substituted or unsubstituted aryl group having 6 to 30 ring carbon atoms or a substituted or unsubstituted heterocyclic group having 5 to 30 ring atoms, and
$Ar^{301}$ is a substituted or unsubstituted 2-naphthyl group or a substituted or unsubstituted fluorenyl group, provided that $Ar^{106}$ and $Ar^{301}$ are different.

**4.** An organic luminescent medium comprising an aromatic amine derivative represented by the following formula (1) and an anthracene derivative represented by the following formula (10):

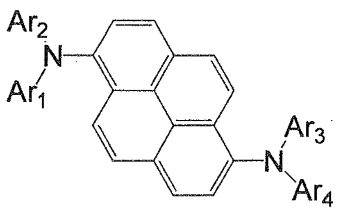
(1)

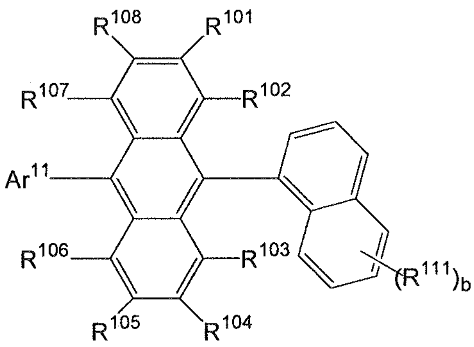

(10)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,

in formula (10), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms, or a substituted or unsubstituted heterocyclic group having 5 to 30 ring atoms,

$Ar^{11}$ is a substituted or unsubstituted phenyl group, substituted or unsubstituted 2-naphthyl group or a substituted or unsubstituted heterocyclic group having 5 to 30 ring atoms,

$R^{111}$ is a substituted or unsubstituted aryl group having 6 to 30 ring carbon atoms, a substituted or unsubstituted heterocyclic group having 5 to 30 ring atoms, a substituted or unsubstituted alkyl group having 1 to 10 carbon atoms, a substituted or unsubstituted cycloalkyl group having 3 to 10 ring carbon atoms, a substituted or unsubstituted alkoxy group having 1 to 20 carbon atoms, a substituted or unsubstituted silyl group, a cyano group or a fluorine atom, and

b is an integer of 0 to 7, and plural $R^{111}$s may be the same or different when b is an integer of 2 or more.

**5.** The organic luminescent medium according to claim 4 wherein the anthracene derivative is represented by the following formula (11):

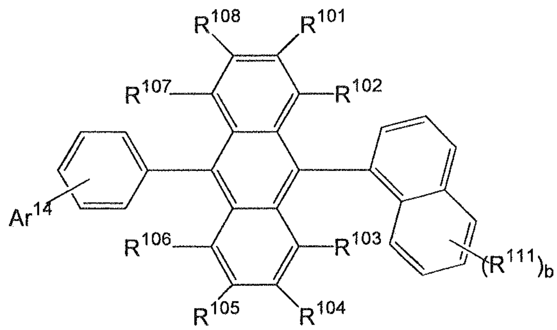

(11)

wherein $R^{101}$ to $R^{108}$, $R^{111}$ and b are the same as those in formula (10), and

$Ar^{14}$ is a substituted or unsubstituted aryl group having 6 to 30 ring carbon atoms, a substituted or unsubstituted alkyl group having 1 to 10 carbon atoms, a substituted or unsubstituted cycloalkyl group having 3 to 10 ring carbon atoms or a substituted or unsubstituted heterocyclic group having 5 to 30 ring atoms.

**6.** An organic luminescent medium comprising an aromatic amine derivative represented by the following formula (1) and an anthracene derivative represented by the following formula (12):

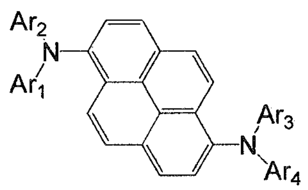

(1)

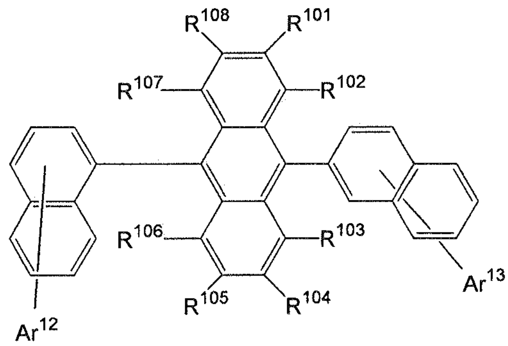

(12)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,
in formula (12), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms, and
$Ar^{12}$ and $Ar^{13}$ are independently a hydrogen atom, an aryl group having 6 to 30 ring carbon atoms, or a substituted or unsubstituted heterocyclic group having 5 to 30 ring atoms, and $Ar^{12}$ may form a ring with the naphthalene ring to which $Ar^{12}$ bonds.

**7.** An organic luminescent medium comprising an aromatic amine derivative represented by the following formula (1) and an anthracene derivative represented by the following formula (13):

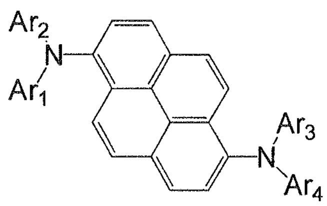

(1)

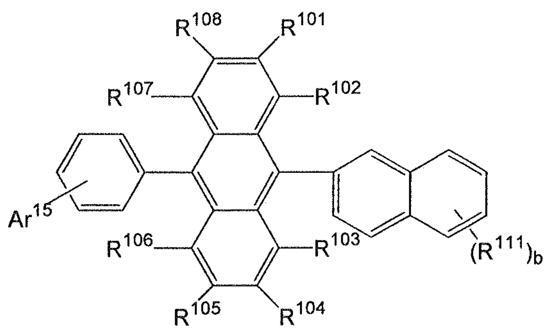

(13)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,
in formula (13), $R^{101}$ to $R^{108}$ and $R^{111}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms,
$Ar^{15}$ is a substituted or unsubstituted aryl group having 6 to 30 ring carbon atoms, a substituted or unsubstituted alkyl group having 1 to 10 carbon atoms, a substituted or unsubstituted cycloalkyl group having 3 to 10 ring carbon atoms or a substituted or unsubstituted heterocyclic group having 5 to 30 ring atoms, and
b is an integer of 0 to 7, and plural $R^{111}$s may be the same or different when b is an integer of 2 or more.

**8.** An organic luminescent medium comprising an aromatic amine derivative represented by the following formula (1) and an anthracene derivative represented by the following formula (14):

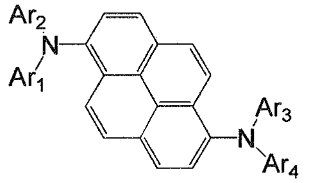
(1)

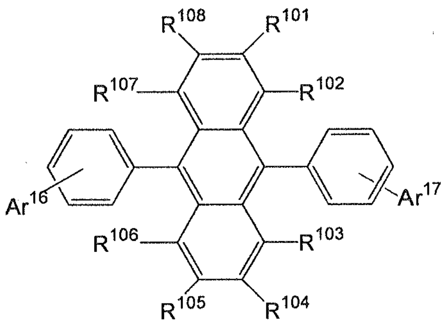
(14)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,
in formula (14), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms,
$Ar^{16}$ is a substituted or unsubstituted aryl group having 6 to 30 ring carbon atoms, a substituted or unsubstituted alkyl group having 1 to 10 carbon atoms, a substituted or unsubstituted cycloalkyl group having 3 to 10 ring carbon atoms or a substituted or unsubstituted heterocyclic group having 5 to 50 ring atoms, and $Ar^{16}$ may form a ring with the benzene ring to which $Ar^{16}$ bonds, and
$Ar^{17}$ is a substituted or unsubstituted aryl group having 6 to 30 ring carbon atoms, a substituted or unsubstituted alkyl group having 1 to 10 carbon atoms, a substituted or unsubstituted cycloalkyl group having 3 to 10 ring carbon atoms or a substituted or unsubstituted heterocyclic group having 5 to 30 ring atoms.

**9.** An organic luminescent medium comprising an aromatic amine derivative represented by the following formula (1) and an anthracene derivative represented by the following formula (15):

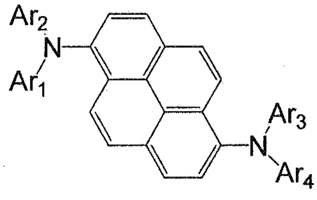

(1)

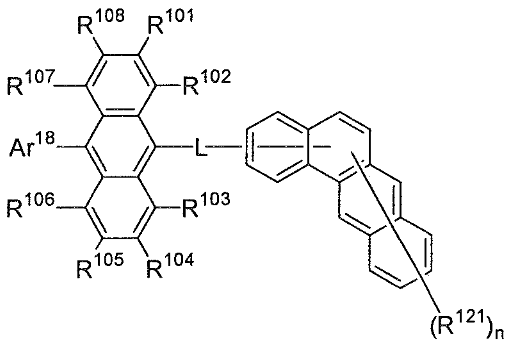

(15)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,

in formula (15), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms, or a substituted or unsubstituted heterocyclic group having 5 to 30 ring atoms,

$Ar^{18}$ is a substituted or unsubstituted aryl group having 6 to 30 ring carbon atoms or a substituted or unsubstituted heterocyclic group having 5 to 30 ring atoms,

L is a single bond, a substituted or unsubstituted arylene group having 6 to 30 ring carbon atoms or a substituted or unsubstituted divalent heterocyclic group having 5 to 30 ring atoms,

$R^{121}$ is a substituted or unsubstituted aryl group having 6 to 30 ring carbon atoms, a substituted or unsubstituted heterocyclic group having 5 to 30 ring atoms, a substituted or unsubstituted alkyl group having 1 to 10 carbon atoms, a substituted or unsubstituted cycloalkyl group having 3 to 10 ring carbon atoms, a substituted or unsubstituted alkoxy group having 1 to 20 carbon atoms, a substituted or unsubstituted silyl group, a cyano group or a fluorine atom, and

n is an integer of 0 to 11, and plural $R^{121}$s may be the same or different when n is an integer of 2 or more.

**10.** An organic luminescent medium comprising an aromatic amine derivative represented by the following formula (1) and an anthracene derivative represented by the following formula (16):

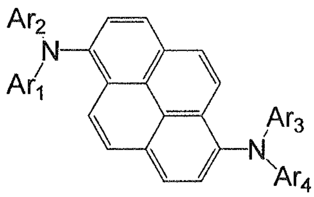

(1)

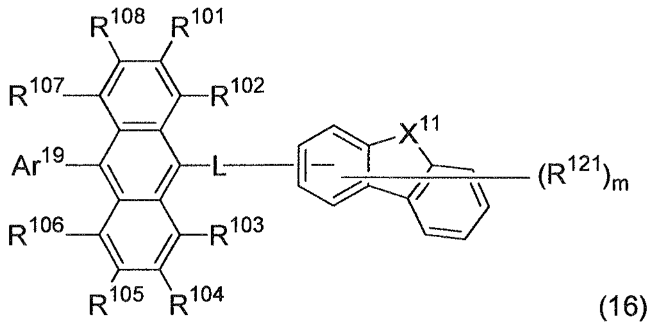

(16)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,
in formula (16), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms,
L is a single bond, a substituted or unsubstituted arylene group having 6 to 50 ring carbon atoms or a substituted or unsubstituted divalent heterocyclic group having 5 to 50 ring atoms,
$Ar^{19}$ is a substituted or unsubstituted aryl group having 6 to 30 ring carbon atoms or a substituted or unsubstituted heterocyclic group having 5 to 30 ring atoms,
$X^{11}$ is an oxygen atom, a sulfur atom, -NR- or $-CR^aR^b$, wherein R, $R^a$ and $R^b$ are the same group as those in $R^{101}$ to $R^{108}$,
$R^{121}$ is a substituted or unsubstituted aryl group having 6 to 30 ring carbon atoms or a substituted or unsubstituted heterocyclic group having 5 to 30 ring atoms, a substituted or unsubstituted alkyl group having 1 to 10 carbon atoms, a substituted or unsubstituted cycloalkyl group having 3 to 10 ring carbon atoms, a substituted or unsubstituted alkoxy group having 1 to 20 carbon atoms, a substituted or unsubstituted silyl group, a cyano group or a fluorine atom, and
m is an integer of 0 to 7, and plural $R^{121}$s may be the same or different when m is an integer of 2 or more.

**11.** An organic luminescent medium comprising an aromatic amine derivative represented by the following formula (1) and an anthracene derivative represented by the following formula (17):

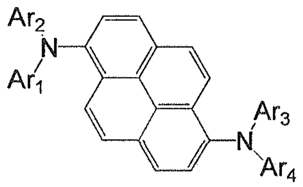

(1)

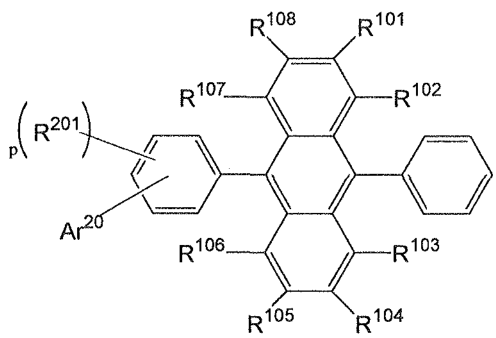

(17)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,

in formula (17), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms,

$Ar^{20}$ is a substituted or unsubstituted aryl group having 6 to 30 ring carbon atoms or a substituted or unsubstituted heterocyclic group having 5 to 30 ring atoms,

$R^{201}$ is a substituted or unsubstituted aryl group having 6 to 30 ring carbon atoms, a substituted or unsubstituted heterocyclic group having 5 to 30 ring atoms, a substituted or unsubstituted alkyl group having 1 to 10 carbon atoms, a substituted or unsubstituted cycloalkyl group having 3 to 10 ring carbon atoms, a substituted or unsubstituted alkoxy group having 1 to 20 carbon atoms, a substituted or unsubstituted silyl group, a cyano group or a fluorine atom, and

p is an integer of 0 to 4, and plural $R^{201}$s may be the same or different when p is an integer of 2 or more.

**12.** An organic luminescent medium comprising an aromatic amine derivative represented by the following formula (1) and an anthracene derivative represented by the following formula (18):

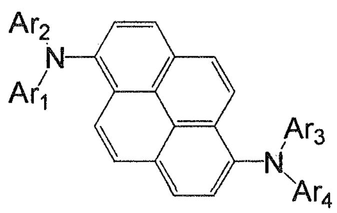

(1)

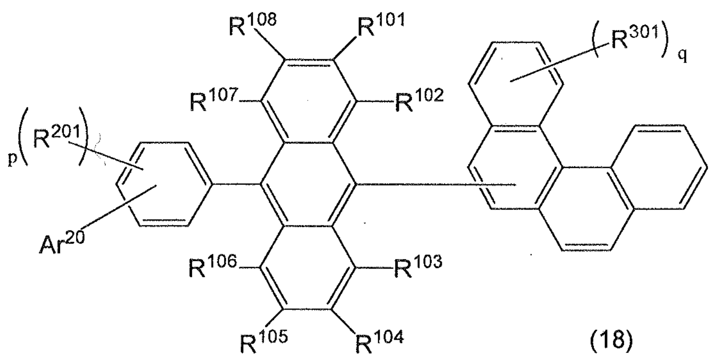

(18)

wherein in formula (1), $Ar_1$ to $Ar_4$ are independently a substituted or unsubstituted aryl group having 6 to 30 ring carbon atoms, and at least one of $Ar_1$ to $Ar_4$ is an aryl group having an electron-attracting group,

in formula (18), $R^{101}$ to $R^{108}$ are independently a hydrogen atom, a fluorine atom, a substituted or unsubstituted alkyl group having 1 to 10 carbon atoms, a substituted or unsubstituted cycloalkyl group having 3 to 10 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aryloxy group having 6 to 20 ring carbon atoms, a substituted or unsubstituted aryl group having 6 to 30 ring carbon atoms or a substituted or unsubstituted heterocyclic group having 5 to 30 ring atoms,

$Ar^{20}$ is a substituted or unsubstituted aryl group having 6 to 30 ring carbon atoms or a substituted or unsubstituted heterocyclic group having 5 to 30 ring atoms,

$R^{201}$ and $R^{301}$ are a substituted or unsubstituted aryl group having 6 to 30 ring carbon atoms or a substituted or unsubstituted heterocyclic group having 5 to 30 ring atoms, a substituted or unsubstituted alkyl group having 1 to 10 carbon atoms, a substituted or unsubstituted cycloalkyl group having 3 to 10 ring carbon atoms, a substituted or unsubstituted alkoxy group having 1 to 20 carbon atoms, a substituted or unsubstituted silyl group, a cyano group

or a fluorine atom,
p is an integer of 0 to 4, and plural $R^{201}$s may be the same or different when p is an integer of 2 or more,
q is an integer of 0 to 11, plural $R^{301}$s may be the same or different when q is an integer of 2 or more, and adjacent substituents may form a saturated or unsaturated ring.

**13.** The organic luminescent medium according to any one of claims 1 to 12 wherein the aromatic amine derivative is represented by the following formula (2):

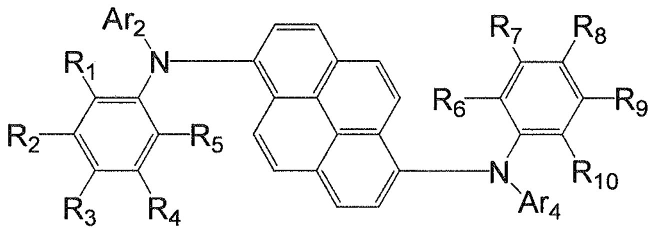

(2)

wherein $Ar_2$ and $Ar_4$ are the same as those in formula (1),
$R_1$ to $R_{10}$ are independently a hydrogen atom, a halogen atom, a substituted or unsubstituted alkyl group having 1 to 20 carbon atoms, a substituted or unsubstituted alkylsilyl group having 3 to 30 carbon atoms, a substituted or unsubstituted arylsilyl group having 8 to 30 ring carbon atoms, a substituted or unsubstituted alkoxy group having 1 to 20 carbon atoms, a substituted or unsubstituted aralkyl group having 6 to 20 ring carbon atoms, a substituted or unsubstituted aryl group having 6 to 10 ring carbon atoms or an electron-attracting group, and
at least one of $R_1$ to $R_5$ is an electron-attracting group, and at least one of $R_6$ to $R_{10}$ is an electron-attracting group.

**14.** The organic luminescent medium according to claim 13 wherein at least one of $R_1$ to $R_5$ is an electron-attracting group and the other groups are a hydrogen atom, and at least one of $R_6$ to $R_{10}$ is an electron-attracting group and the other groups are a hydrogen atom.

**15.** The organic luminescent medium according to any one of claims 1 to 14 wherein the electron-attracting group is a cyano group.

**16.** An organic thin film comprising the organic luminescent medium according to any one of claims 1 to 15.

**17.** An organic electroluminescence device comprising one or more organic thin film layers comprising an emitting layer between an anode and an cathode,
wherein at least one layer of the organic thin film layers is the organic thin film according to claim 16.

**INTERNATIONAL SEARCH REPORT**

International application No.
PCT/JP2010/007270

A. CLASSIFICATION OF SUBJECT MATTER
*C09K11/06*(2006.01)i, *H01L51/50*(2006.01)i

According to International Patent Classification (IPC) or to both national classification and IPC

B. FIELDS SEARCHED

Minimum documentation searched (classification system followed by classification symbols)
C09K11/06, H01L51/50

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)
CA/REGISTRY(STN)

C. DOCUMENTS CONSIDERED TO BE RELEVANT

| Category* | Citation of document, with indication, where appropriate, of the relevant passages | Relevant to claim No. |
|---|---|---|
| A | JP 2008-214332 A (SFC Co., Ltd.), 18 September 2008 (18.09.2008), claims (particularly, claims 2, 3); examples & US 2008/0203905 A1 & KR 10-2008-0079956 A | 1-17 |
| A | JP 2007-027779 A (LG Electronics Inc.), 01 February 2007 (01.02.2007), claims; paragraphs [0008] to [0009], [0020] to [0021](particularly, S-4, 5, 49, 50); examples & JP 2004-204238 A & US 2004/0137270 A1 & US 2010/0155714 A1 & EP 1437395 A2 & KR 10-2004-0057862 A & CN 1535089 A | 1-17 |

☒ Further documents are listed in the continuation of Box C. ☐ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| 03 March, 2011 (03.03.11) | 15 March, 2011 (15.03.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No. PCT/JP2010/007270

C (Continuation). DOCUMENTS CONSIDERED TO BE RELEVANT

| Category* | Citation of document, with indication, where appropriate, of the relevant passages | Relevant to claim No. |
|---|---|---|
| A | JP 2004-204238 A (LG Electronics Inc.), 22 July 2004 (22.07.2004), claims (particularly, claims 2, 4); paragraph [0008]; examples<br>& JP 2007-27779 A & US 2004/0137270 A1<br>& US 2010/0155714 A1 & EP 1437395 A2<br>& KR 10-2004-0057862 A & CN 1535089 A | 1-17 |
| A | JP 2008-244424 A (Mitsubishi Chemical Corp.), 09 October 2008 (09.10.2008), claims; paragraphs [0100] to [0103], [0115] to [0122], [0210]; examples (particularly, example 30)<br>(Family: none) | 1-17 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020070115588
- KR 1020080079956
- WO 2005108348 A
- WO 2004018588 A
- WO 2004018587 A
- WO 2009102054 A
- WO 2009102026 A
- WO 2009107596 A